# EUROPEAN PATENT APPLICATION

(11) **EP 4 827 267 A1**
(43) Date of publication of application: **21.10.2026**
(21) Application number: 25219138.2
(22) Date of filing: 27.11.2025
(51) Int. Cl.: H10D 12/01, H10D 12/00, H10D 30/01, H10D 30/66, H10D 62/10, H10D 62/13, H10D 62/822, H10D 62/832, H10D 18/01, H10D 18/60

(54) **SEMICONDUCTOR DEVICE INCLUDING A BUFFER LAYER**

(30) Priority: 18.04.2025 KR 20250050862
(71) Applicant: Samsung Electronics Co., Ltd, Suwon-si, Gyeonggi-do 16677 (KR)
(72) Inventor: KIM, Jonghak, Suwon-si (KR); PARK, Sanghoo, Suwon-si (KR); JANG, Sehee, Suwon-si (KR); JEONG, Wonkyeong, Suwon-si (KR)
(74) Representative: Marks & Clerk LLP

(57) **Abstract**

An example semiconductor device is a SiC semiconductor device, including a buffer layer, a first conductivity type semiconductor layer on a first surface of the buffer layer, a second conductivity type well region in the first conductivity type semiconductor layer, a first conductivity type well region in the second conductivity type well region, a gate electrode adjacent to the second conductivity type well region, a gate insulating layer between the gate electrode and the second conductivity type well region, a first electrode on the first conductivity type well region, and a second electrode on a second surface of the buffer layer, the second surface being opposite the first surface. The buffer layer includes a first buffer layer including a first element homologous to Si, and, in the first buffer layer, the content of the first element is 10 at% to 50 at%.

## Description

### BACKGROUND

In modern society, semiconductor devices are closely related to everyday life. In particular, the importance of power semiconductor devices used in various fields such as transportation fields including electric vehicles, railroads, electric trams, renewable energy systems such as solar power generation and wind power generation, and mobile devices is gradually increasing. A power semiconductor device is a semiconductor device used to handle high voltage or high current, and performs functions such as power conversion and control in large-scale power systems or high-output electronic devices. A power semiconductor device has the ability to handle high power and durability, and may handle a large amount of current and withstand high voltage. For example, a power semiconductor device may handle a voltage of several hundred volts to several thousand volts and a current of several tens of amperes to several thousand amperes. A power semiconductor device may minimize power loss to improve the efficiency of electric energy. In addition, the power semiconductor device may be stably operated even in environments such as high temperature.

### SUMMARY

The present disclosure relates to a semiconductor device having improved electrical characteristics and reliability by preventing a dislocation from propagating to an upper layer.

Power semiconductor devices may be classified according to materials being used, such as silicon carbide (SiC) power semiconductor devices and gallium nitride (GaN) power semiconductor devices. SiC or GaN power semiconductor devices may compensate for disadvantages of silicon having unstable characteristics at high temperatures. For example, SiC power semiconductor devices may be resistant to high temperatures, may have low power loss, and may be suitable for electric vehicles, renewable energy systems, and the like.

In some implementations, a semiconductor device is a SiC semiconductor device, including a buffer layer, a first conductivity type semiconductor layer on a first surface of the buffer layer, a second conductivity type well region in the first conductivity type semiconductor layer, a first conductivity type well region in the second conductivity type well region, a gate electrode adjacent to the second conductivity type well region, a gate insulating layer between the gate electrode and the second conductivity type well region, a first electrode on the first conductivity type well region, and a second electrode on a second surface of the buffer layer, which is an opposite surface to the first surface. The buffer layer includes a first buffer layer including a first element that is homologous to Si, and the content of the first element in the first buffer layer is 10 at% to 50 at%.

In some implementations, a semiconductor device is a SiC semiconductor device, including a buffer layer, a first conductivity type semiconductor layer on a first surface of the buffer layer, a second conductivity type well region in the first conductivity type semiconductor layer, a first conductivity type well region in the second conductivity type well region, a gate electrode adjacent to the second conductivity type well region, a gate insulating layer between the gate electrode and the second conductivity type well region, a first electrode on the first conductivity type well region, and a second electrode on a second surface of the buffer layer, which is opposite to the first surface. The buffer layer includes a first buffer layer and a second buffer layer including SiₚX_{q}C_{1-p-q}, where X is an element homologous to Si, and where in the first buffer layer, the composition of SiₚX_{q}C_{1-p-q} is p>0, 0.1≤q≤0.5, and in the second buffer layer, the composition of SiₚX_{q}C_{1-p-q} is p>0, 0≤q≤0.01.

In some implementations, a semiconductor device is a SiC semiconductor device, including a buffer layer, a first semiconductor layer of a first conductivity type sequentially stacked on a first surface of the buffer layer, a second semiconductor layer of a second conductivity type, a third semiconductor layer of the first conductivity type, and a fourth semiconductor layer of the second conductivity type, a gate electrode on an upper surface of the second semiconductor layer or the third semiconductor layer, a first electrode on an upper surface of the fourth semiconductor layer, and a second electrode on a second surface of the buffer layer, which is an opposite surface to the first surface, and the buffer layer includes a first buffer layer including a first element homologous to Si, and a content of the first element in the first buffer layer is 10 at% to 50 at%.

In some implementations, it may be possible to improve the electrical characteristic and reliability of a semiconductor device by preventing dislocation from propagating to the upper layer.

At least some of the above and other features of the invention are set out in the claims.

### BRIEF DESCRIPTION OF THE DRAWINGS

FIG. 1 is a cross-sectional view of an example of a semiconductor device.
FIG. 2 is a cross-sectional view of an example of a semiconductor device.
FIG. 3 is a cross-sectional view of an example of a semiconductor device.
FIG. 4 is a cross-sectional view of an example of a semiconductor device.
FIG. 5 is a cross-sectional view of an example of a semiconductor device.
FIG. 6 is a cross-sectional view of an example of a semiconductor device.
FIG. 7 is a cross-sectional view of an example of a semiconductor device.
FIG. 8 is a cross-sectional view of an example of a semiconductor device.
FIG. 9 is a cross-sectional view of an example of a semiconductor device.
FIG. 10 is a cross-sectional view of an example of a semiconductor device.
FIG. 11 is a cross-sectional view of an example of a semiconductor device.
FIG. 12 is a cross-sectional view of an example of a semiconductor device.
FIG. 13 is a cross-sectional view of an example of a semiconductor device.
FIG. 14 is a cross-sectional view of an example of a semiconductor device.
FIG. 15 is a cross-sectional view of an example of a semiconductor device.
FIGS. 16, 17, 18, 19, 20, 21, 22, and 23 are cross-sectional views illustrating an example of a method of manufacturing a semiconductor device.

### DETAILED DESCRIPTION

Hereinafter, various implementations of the present disclosure will be described in detail with reference to the accompanying drawings so that those having ordinary skill in the art to which the present disclosure pertains may readily carry out the disclosure. The present disclosure may be implemented in various different forms and is not limited to the implementations described herein.

In order to clearly explain the present disclosure, portions not related to the description have been omitted, and throughout the entire specification, the same reference numerals are assigned to identical or similar components.

In addition, the size and thickness of each component shown in the drawings are illustrated arbitrarily for convenience of explanation, and the present disclosure is not necessarily limited to what is depicted. The thicknesses are illustrated in an enlarged manner in the drawings in order to clearly represent various layers and regions. In the drawings, for convenience of explanation, the thicknesses of some layers and regions are exaggerated.

In addition, when a part such as a layer, film, region, or plate is described as being on or above another part, this includes not only cases where it is directly on the other part, but also cases where another part is positioned therebetween. Conversely, when it is stated that a certain part is "directly on" another part, it means that there is no other part in between. In addition, stating that it is "on" or "above" a reference part means that it is positioned above or below the reference part, and does not necessarily mean that it is "on" or "above" in a direction opposite to gravity. The terms "upper", "middle", "lower" may refer to relative positions along a particular direction (e.g. a vertical direction, or Z direction). For instance, a Z direction may be defined perpendicular to one or more layers, and the Z direction may be a vertical, or height, direction. Various directions (e.g. vertical direction, horizontal direction, etc.) may be defined relative to the structure of the devices described herein. It will be appreciated that these directions do not necessarily imply any particular orientation of the device in use.

In addition, throughout the specification, when a part is referred to as "including" a certain component, this means that, unless specifically stated otherwise, the component does not exclude the presence of other components but may further include other components.

In addition, throughout the specification, "in a plan view" refers to when the target portion is viewed from above, and "in a cross-sectional view" refers to when the cross-section of the target portion, cut vertically, is viewed from the side.

As used herein, the terms "substantially," "about," and similar terms are used as terms of approximation and not as terms of degree, and are intended to account for the inherent variations in measured or calculated values that would be recognized by those of ordinary skill in the art. Parameters and/or ends of ranges that are quoted as being "about" a certain value (e.g. "about X") may be considered equal to that value (e.g. "equal to X"). Nevertheless, any values quoted herein may include variations of that value within commonly accepted errors, margins and/or tolerances (e.g. manufacturing tolerances). For instance, any values quoted herein may also cover variations within ±5% or ±10%.

As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

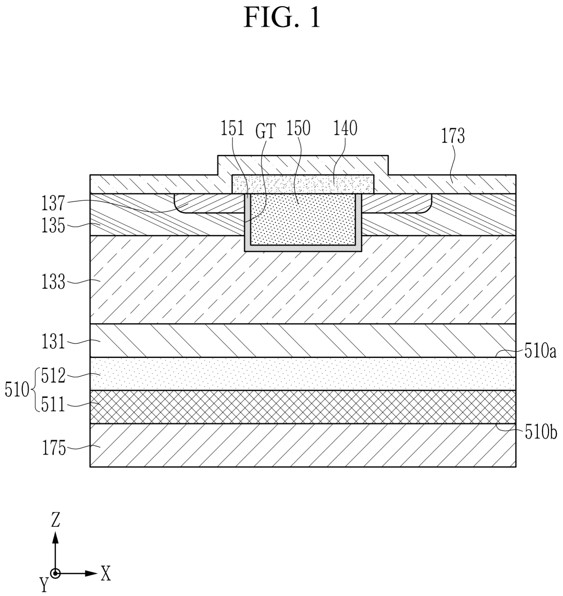

Hereinafter, a semiconductor device will be described with reference to FIG. 1.

FIG. 1 is a cross-sectional view of an example of a semiconductor device.

The semiconductor device may be a SiC semiconductor device. The semiconductor device may include at least one SiC-based semiconductor layer formed on a SiC substrate, and at least one well region formed in the semiconductor layer, and may further include a plurality of electrodes electrically connected to the semiconductor layer and the well region. The semiconductor device may not include a SiC substrate in the final structure, but at least one semiconductor layer and at least one well region may include SiC.

As illustrated in FIG. 1, a semiconductor device includes a buffer layer 510, a first conductivity type semiconductor layer 133 (e.g., a semiconductor layer of a first conductivity type) positioned on a first surface 510a of the buffer layer 510, a second conductivity type well region 135 (e.g., a well region of a second conductivity type) positioned within the first conductivity type semiconductor layer 133, a first conductivity type well region 137 (e.g., a well region of the first conductivity type) positioned within the second conductivity type well region 135, a gate electrode 150 adjacent to the second conductivity type well region 135, a first electrode 173 positioned on the first conductivity type well region 137, and a second electrode 175 positioned on a second surface 510b of the buffer layer 510, wherein the second surface 510b is opposite to the first surface 510a.

The semiconductor device may include a second conductivity type semiconductor layer 131 (e.g., a semiconductor layer of the second conductivity type) between the buffer layer 510 and the first conductivity type semiconductor layer 133.

According to an implementation, the semiconductor device does not include a substrate; however, the implementation is not limited thereto. For example, a substrate may be positioned between the buffer layer 510 and the second electrode 175. For example, the semiconductor device may include the buffer layer 510, the second conductivity type semiconductor layer 131, the first conductivity type semiconductor layer 133, the second conductivity type well region 135, the first conductivity type well region 137, the gate electrode 150, and the first electrode 173 on a first surface of a substrate, and may include the second electrode 175 on a second surface of the substrate which is opposite to the first surface. In this case, the substrate may be a semiconductor substrate including SiC. For example, the substrate may be formed of a 4H SiC substrate. In some cases, the substrate may be formed of a 3C SiC substrate, a 6H SiC substrate, or the like. The substrate may have a first conductivity type. The substrate may be doped at a low concentration with the first conductivity type (e.g., a doping concentration that is less than that for the first conductivity type semiconductor layer 133). The first conductivity type may be n-type, but is not limited thereto. The resistivity of the substrate may be about 0.005 Ω·cm or more and about 0.035 Ω·cm or less. The thickness of the substrate may be about 10 µm or more and about 700 µm or less. The material, doping type, doping concentration, resistivity, thickness, and the like of the substrate are not limited thereto and may be variously modified. An implementation illustrated in FIG. 1 may be an example in which a substrate is removed from the final structure of the semiconductor device after the substrate is used in the manufacturing process.

The second conductivity type semiconductor layer 131, the first conductivity type semiconductor layer 133, the second conductivity type well region 135, and the first conductivity type well region 137 may include the same semiconductor material. For example, the second conductivity type semiconductor layer 131 and the first conductivity type semiconductor layer 133 may be formed through an epitaxial growth process using the same semiconductor material as a seed. For example, the second conductivity type well region 135 and the first conductivity type well region 137 may be formed by doping impurities (for example, ions) into the first conductivity type semiconductor layer 133 through an ion implantation process. The second conductivity type semiconductor layer 131, the first conductivity type semiconductor layer 133, the second conductivity type well region 135, and the first conductivity type well region 137 may include SiC.

The second conductivity type semiconductor layer 131, the first conductivity type semiconductor layer 133, the second conductivity type well region 135, and the first conductivity type well region 137 may include a semiconductor material doped with an impurity. The first conductivity type semiconductor layer 133 and the first conductivity type well region 137 may include a semiconductor material doped with an impurity of the first conductivity type. The second conductivity type semiconductor layer 131 and the second conductivity type well region 135 may include a semiconductor material doped with an impurity of the second conductivity type. The first conductivity type and the second conductivity type may be different (e.g., opposite). For example, the first conductivity type may be n-type, and the second conductivity type may be p-type. Alternatively, the first conductivity type may be p-type, and the second conductivity type may be n-type.

The first conductivity type semiconductor layer 133 may be positioned on the upper surface of the second conductivity type semiconductor layer 131. The doping concentration of the first conductivity type semiconductor layer 133 may be about 1*10¹⁴ cm⁻³ or more and about 1*10¹⁷ cm⁻³ or less. The thickness of the first conductivity type semiconductor layer 133 in the third direction Z may be about 1 µm or more and about 13 µm or less. The third direction Z may be a direction perpendicular to an upper surface of the first conductivity type semiconductor layer 133. The doping concentration and the thickness in the third direction Z of the first conductivity type semiconductor layer 133 are not limited thereto and may be variously changed.

The second conductivity type well region 135 may extend from an upper surface of the first conductivity type semiconductor layer 133 toward a lower surface of the first conductivity type semiconductor layer 133, and may have a depth in the third direction Z. An upper surface of the second conductivity type well region 135 may be positioned at the same level as an upper surface of the first conductivity type semiconductor layer 133. A lower surface of the second conductivity type well region 135 may be positioned at a higher level than a lower surface of the first conductivity type semiconductor layer 133.

The doping concentration of the second conductivity type well region 135 may be about 1*10¹⁷ cm⁻³ or more and about 1*10¹⁹ cm⁻³ or less. The thickness of the second conductivity type well region 135 in the third direction Z may be about 0.3 µm or more and about 1.1 µm or less. The doping concentration and the thickness in the third direction Z of the second conductivity type well region 135 are not limited thereto and may be variously changed.

The first conductivity type well region 137 extends from the upper surface of the first conductivity type semiconductor layer 133 toward the lower surface of the first conductivity type semiconductor layer 133, and may have a depth in the third direction Z. The upper surface of the first conductivity type well region 137 may be positioned at the same level as the upper surface of the first conductivity type semiconductor layer 133. A lower surface of the first conductivity type well region 137 may be positioned at a higher level than a lower surface of the first conductivity type semiconductor layer 133.

The first conductivity type well region 137 may be positioned within the second conductivity type well region 135. The first conductivity type well region 137 extends from an upper surface of the second conductivity type well region 135 toward a lower surface of the second conductivity type well region 135, and may have a depth along a third direction Z. The depth (or thickness) in the third direction Z of the first conductivity type well region 137 may be shallower than the depth (or thickness) in the third direction Z of the second conductivity type well region 135. The upper surface of the first conductivity type well region 137 may be positioned at the same level as the upper surface of the second conductivity type well region 135. The lower surface of the first conductivity type well region 137 may be positioned at a higher level than the lower surface of the second conductivity type well region 135. The first conductivity type well region 137 may be surrounded by the second conductivity type well region 135. The lower surface and one side surface of the first conductivity type well region 137 may be surrounded by the second conductivity type well region 135.

The doping concentration of the first conductivity type well region 137 may be about 1*10¹⁷ cm⁻³ or more and about 5*10²⁰ cm⁻³ or less. The thickness of the first conductivity type well region 137 in the third direction Z may be about 0.1 µm or more and about 0.5 µm or less. The doping concentration and the thickness according to the third direction Z of the first conductivity type well region 137 are not limited thereto and may be variously changed.

The second conductivity type semiconductor layer 131 may be positioned on the first surface 510a of the buffer layer 510. The doping concentration of the second conductivity type semiconductor layer 131 may be higher than the doping concentration of the second conductivity type well region 135, but is not limited thereto. The thickness of the second conductivity type semiconductor layer 131 in the third direction Z may be smaller than the thickness of the first conductivity type semiconductor layer 133 in the third direction Z, but is not limited thereto.

The semiconductor device may include a plurality of first conductivity type well regions 137 spaced apart in a first direction X and a plurality of second conductivity type well regions 135 spaced apart in the first direction X. The first direction X may be a direction parallel to an upper surface of the first conductivity type semiconductor layer 133. A gate trench GT may be positioned between the plurality of first conductivity type well regions 137 spaced apart in the first direction X, and between the plurality of second conductivity type well regions 135 spaced apart in the first direction X.

The gate trench GT may extend in the third direction Z from the upper surface of the first conductivity type semiconductor layer 133 toward the lower surface of the first conductivity type semiconductor layer 133. The gate trench GT may have a depth in the third direction Z. A lower portion of the gate trench GT may be surrounded by an upper portion of the first conductivity type semiconductor layer 133. The bottom surface of the gate trench GT may be formed by the upper surface of the first conductivity type semiconductor layer 133. The sidewall of a gate trench GT may be formed of a side surface of the first conductivity type well region 137, a side surface of the second conductivity type well region 135, and a side surface of the first conductivity type semiconductor layer 133.

The gate trench GT may extend in the second direction Y. The second direction Y may be parallel to the upper surface of the first conductivity type semiconductor layer 133 and may be a direction intersecting the first direction X. For example, the second direction Y may be a direction perpendicular to the first direction X. The first direction X and the second direction Y may be perpendicular to the third direction Z.

The gate electrode 150 and the gate insulating layer 151 may be positioned in the gate trench GT. The gate insulating layer 151 may cover the sidewalls and the bottom surface of the gate trench GT. The gate electrode 150 may be positioned on the gate insulating layer 151. The gate electrode 150 may fill the remaining space of the gate trench GT. Both side surfaces and the lower surface of the gate electrode 150 may be surrounded by the gate insulating layer 151. The gate electrode 150 may be spaced apart from the first conductivity type semiconductor layer 133, the second conductivity type well region 135, and the first conductivity type well region 137 by the gate insulating layer 151.

The gate electrode 150 may overlap the first conductivity type well region 137 and the second conductivity type well region 135 in the first direction X. The gate electrode 150 may overlap the first conductivity type semiconductor layer 133 in the first direction X and the third direction Z. The term "overlap in a direction" may refer to two elements that are positioned such that a line parallel to the direction passes through at least a portion of each element. For instance, the two elements may at least partially obstruct each other when viewed along the direction.

The upper surface of the gate electrode 150 may be positioned at the same level as the upper surface of the second conductivity type well region 135 and the upper surface of the first conductivity type well region 137, but is not limited thereto. For example, the upper surface of the gate electrode 150 may be positioned at a lower level than the upper surface of the second conductivity type well region 135 and the upper surface of the first conductivity type well region 137.

In the implementation shown in FIG. 1, as the gate electrode 150 is positioned in the gate trench GT, it overlaps the second conductivity type well region 135 and the first conductivity type well region 137 in the first direction X, but the implementation is not limited thereto. For example, the gate electrode 150 may be positioned on the upper surface of the first conductivity type semiconductor layer 133, on the upper surface of the second conductivity type well region 135, and on the upper surface of the first conductivity type well region 137. In this case, the gate electrode 150 may overlap the second conductivity type well region 135 and the first conductivity type well region 137 in the third direction Z.

The gate electrode 150 may include a conductive material. For example, the gate electrode 150 may include polysilicon doped with an impurity, but is not limited thereto. As another example, the gate electrode 150 may include a metal, an alloy, a conductive metal nitride, a metal silicide, a semiconductor material doped with an impurity, a conductive metal oxide, a conductive metal oxynitride, or a combination thereof. The gate electrode 150 may be formed of a single layer or multiple layers.

The gate insulating layer 151 may include an insulating material. For example, the gate insulating layer 151 may include silicon oxide, but is not limited thereto. In another example, the gate insulating layer 151 may include silicon nitride, silicon oxynitride, silicon carbide, silicon carbonitride, or a combination thereof. The gate insulating layer 151 may be formed as a single layer or as a multilayer.

The semiconductor device may include a protective layer positioned on the gate insulating layer 151 and the gate electrode 150. The protective layer 140 may be positioned further on the first conductivity type well region 137. The protective layer 140 may cover the upper surface of the gate electrode 150 and the upper surface of the gate insulating layer 151. The protective layer 140 may cover a portion of an upper surface of the first conductivity type well region 137.

The protective layer 140 may include an insulating material. For example, the protective layer 140 may include silicon oxide, silicon phosphoxide, silicon nitride, silicon oxynitride, or a combination thereof, but is not limited thereto. The protective layer 140 may be formed as a single layer or a multilayer.

In some implementations, the protective layer 140 may include the same material as the gate insulating layer 151, but is not limited thereto. When the protective layer 140 includes the same material as the gate insulating layer 151, the boundary between the protective layer 140 and the gate insulating layer 151 at the portion where the protective layer 140 and the gate insulating layer 151 are in contact may not be clearly distinguished.

The first electrode 173 may be positioned on the first conductivity type well region 137. The first electrode 173 may be positioned further on the second conductivity type well region 135. The first electrode 173 may be positioned further on the protective layer 140. The first electrode 173 may overlap the gate electrode 150 in the third direction Z. The first electrode 173 may be spaced apart from the gate electrode 150 in the third direction Z and the first direction X by the protective layer 140.

The first electrode 173 may be electrically connected to the first conductivity type well region 137. For example, the first electrode 173 may contact an upper surface of the first conductivity type well region 137, but is not limited thereto. Another layer may be further positioned between the first electrode 173 and the first conductivity type well region 137. The first electrode 173 may be positioned at both sides of the gate electrode 150 and may be connected to the plurality of first conductivity type well regions 137 spaced apart in the first direction X.

The first electrode 173 may also be electrically connected to the second conductivity type well region 135. For example, the first electrode 173 may contact an upper surface of the second conductivity type well region 135, but is not limited thereto. Another layer may be further positioned between the first electrode 173 and the second conductivity type well region 135. The first electrode 173 may be positioned at both sides of the gate electrode 150 and may be connected to the plurality of second conductivity type well regions 135 spaced apart in the first direction X.

The second electrode 175 may be positioned on the second surface 510b of the buffer layer 510. The second electrode 175 may be electrically connected to the second conductivity type semiconductor layer 131 through the buffer layer 510.

The first electrode 173 and the second electrode 175 may include a conductive material. For example, the first electrode 173 and the second electrode 175 may include metal, alloy, conductive metal nitride, metal silicide, semiconductor material doped with an impurity, conductive metal oxide, conductive metal oxynitride, or a combination thereof. The first electrode 173 and the second electrode 175 each may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAlN), tungsten nitride (WN), ruthenium (Ru), titanium aluminum (TiAl), titanium aluminum carbonitride (TiAIC-N), titanium aluminum carbide (TiAIC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or combinations thereof, but are not limited thereto. The first electrode 173 and the second electrode 175 each may be formed as a single layer or a multilayer.

In some implementations, the second electrode 175 may include a material different from the first electrode 173, but is not limited thereto.

The semiconductor device may be an insulated gate bipolar transistor (IGBT). The second conductivity type semiconductor layer 131, the first conductivity type semiconductor layer 133, and the second conductivity type well region 135 may constitute a bipolar junction transistor (BJT) (e.g., of a PNP structure). At this time, the first conductivity type semiconductor layer 133 may be the base region of the BJT. The first conductivity type semiconductor layer 133, the gate electrode 150, the gate insulating layer 151, and the first conductivity type well region 137 may constitute a MOSFET. The first conductivity type well region 137 may be a source region of the MOSFET, and the first conductivity type semiconductor layer 133 may be a drain region of the MOSFET. The second conductivity type well region 135 adjacent to the gate electrode 150 may be a channel region. When a channel is formed in the second conductivity type well region 135 by a voltage applied to the gate electrode 150, current may flow between the first conductivity type well region 137 and the first conductivity type semiconductor layer 133. Accordingly, the BJT may be turned on. For example, a current may flow between the first electrode 173 and the second electrode 175. Excellent switching characteristics may be secured by the MOSFET, and excellent current operation characteristics may be secured by the BJT. An IGBT may, for example, be used as a power device; however, the application is not limited thereto and may be variously modified. When the semiconductor device is an IGBT, the first electrode 173 may be referred to as an emitter electrode, and the second electrode 175 may be referred to as a collector electrode.

In the case of an SiC semiconductor device, some of the basal plane dislocations existing along the basal plane of the SiC substrate may be extended in the crystal growth direction as threading dislocations through an epitaxial growth process proceeding on the SiC substrate. Such threading dislocation may degrade the electrical performance and reliability of the SiC semiconductor device by causing an increase in leakage current and a decrease in breakdown voltage.

The semiconductor device may include the buffer layer 510 between a SiC substrate and a semiconductor layer formed on the SiC substrate by an epitaxial growth process. The buffer layer 510 may serve to mitigate crystal defects propagated from the substrate. Accordingly, the electrical performance and reliability of the semiconductor device may be improved.

In some implementations, when the SiC substrate is omitted from the final structure of the semiconductor device, the buffer layer 510 may be positioned between the second electrode 175 and the semiconductor layer. For example, when the semiconductor device includes a plurality of semiconductor layers formed by an epitaxial growth process, the buffer layer 510 may be positioned between the lowermost semiconductor layer among the plurality of semiconductor layers and the second electrode 175.

The semiconductor device may include the second conductivity type semiconductor layer 131 and the first conductivity type semiconductor layer 133 formed on a SiC substrate through an epitaxial growth process. In this case, among the second conductivity type semiconductor layer 131 and the first conductivity type semiconductor layer 133, the second conductivity type semiconductor layer 131 may be the lowermost semiconductor layer. The buffer layer 510 of the semiconductor device may be positioned between the second conductivity type semiconductor layer 131 which is the lowermost semiconductor layer, and the second electrode 175.

The buffer layer 510 may include the first surface 510a and the second surface 510b opposite to the first surface 510a. The second conductivity type semiconductor layer 131 and the first conductivity type semiconductor layer 133 are positioned on the first surface 510a of the buffer layer 510, and the second electrode 175 may be positioned on the second surface 510b of the buffer layer 510.

The buffer layer 510 may include the same semiconductor material as the second conductivity type semiconductor layer 131 and the first conductivity type semiconductor layer 133. For example, the buffer layer 510 may be formed through an epitaxial growth process using the same semiconductor material as the second conductivity type semiconductor layer 131 and the first conductivity type semiconductor layer 133 as a seed. The buffer layer 510 may include SiC.

The buffer layer 510 may include a semiconductor material doped with impurities. The buffer layer 510 may include a semiconductor material doped with a first conductivity type impurity. For example, the first conductivity type may be n-type.

The buffer layer 510 may include a first buffer layer 511 including a first element (X) homologous to Si. The first buffer layer 511 may include SiₚX_{q}C_{1-p-q}. The content of the first element (X) in the first buffer layer 511 may be about 10 at% to about 50 at%. That is, in the first buffer layer 511, the composition of SiₚX_{q}C_{1-p-q} may be p>0 and 0.1≤q≤0.5. Two elements that are homologous may occupy the same group in the periodic table. Accordingly, the first element (X) may be a Group 14 element (e.g., a Group 14 element other than Si). For instance, the first element may be C or Ge.

For example, the first element (X) may be Ge. When the first element (X) is Ge, the first buffer layer 511 may include SiₚGe_{q}C_{1-p-q}. The composition of SiₚGe_{q}C_{1-p-q} within the first buffer layer 511 may be p>0 and 0.1≤q≤0.5. However, the implementations are not limited thereto, and the first element (X) may be variously changed.

For example, the first element (X) may be C. In this case, the first buffer layer 511 may include SiCₘ, and m may be greater than 1. That is, in the first buffer layer 511, the content (at%) of C may be higher than the content (at%) of Si.

The thickness of the first buffer layer 511 in the third direction Z may be less than or equal to 30 nm (e.g., may be greater than about 0 nm and less than or equal to about 30 nm). When the thickness of the first buffer layer 511 in the third direction Z is greater than about 0 nm and less than or equal to about 30 nm, the distance that defects are propagated through the first buffer layer 511 may be shortened, thereby reducing the defect density reaching the upper layer of the first buffer layer 511.

In some implementations, the buffer layer 510 may further include a second buffer layer 512. The second buffer layer 512 may be positioned on the first buffer layer 511. The second buffer layer 512 may be positioned between the first buffer layer 511 and the second conductivity type semiconductor layer 131. The content of the first element (X) in the second buffer layer 512 may be different from the content of the first element (X) in the first buffer layer 511. The content of the first element (X) in the second buffer layer 512 may be lower than the content of the first element (X) in the first buffer layer 511. For example, in the second buffer layer 512, the content of the first element (X) may be about 0 at% to about 1 at%. The second buffer layer 512 may include SiₚX_{q}C_{1-p-q}, where p > 0 and 0 ≤ q ≤ 1. For example, the second buffer layer 512 may not include the first element (X). In this case, the second buffer layer 512 may include SiC. As another example, the second buffer layer 512 may include the first element (X), but the content of the first element (X) may be about 1 at% or less. In this case, the second buffer layer 512 may include SiₚX_{q}C_{1-p-q}, where p>0 and 0<q≤1.

The buffer layer 510 of the semiconductor device includes the first buffer layer 511 including a first element homologous to Si, and as the content of the first element in the first buffer layer 511 is about 10 at% to about 50 at%, it may be possible to prevent threading dislocations from propagating through a semiconductor layer (for example, the second conductivity type semiconductor layer 131 and/or the first conductivity type semiconductor layer 133) positioned on the buffer layer 510.

According to one implementation, the buffer layer 510 of the semiconductor device includes the second buffer layer 512 including a first element homologous to Si, and since the content of the first element in the second buffer layer 512 is about 1 at% or less, the film quality of a semiconductor layer (for example, the second conductivity type semiconductor layer 131 and/or the first conductivity type semiconductor layer 133) positioned on the buffer layer 510 may be improved.

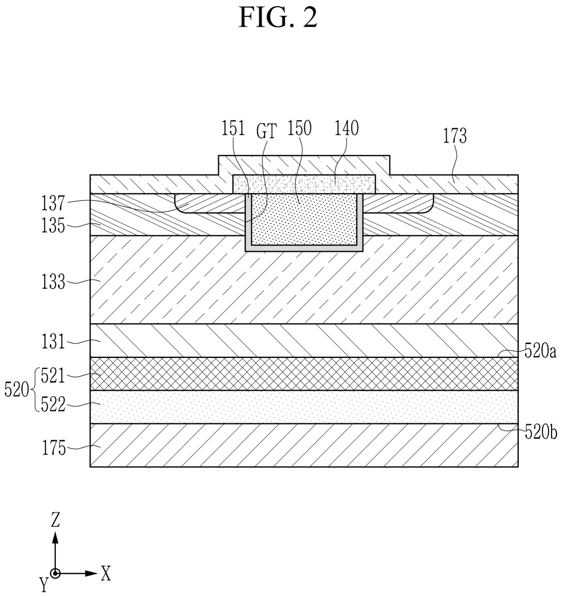

Hereinafter, with reference to FIG. 2, a modified example of the semiconductor device according to the implementation shown in FIG. 1 will be described.

FIG. 2 is a cross-sectional view of an example of a semiconductor device. In the implementation shown in FIG. 2, a buffer layer 520, a first buffer layer 521, and a second buffer layer 522 may correspond to the buffer layer 510, the first buffer layer 511, and the second buffer layer 512 of the implementation shown in FIG. 1. In the implementation shown in FIG. 2, components identical to the components of the implementation shown in FIG. 1 may be referred to by the same drawing reference numerals. The implementation shown in FIG. 2 may have the positional relationship of the first buffer layer 521 and the second buffer layer 522 partially different from the implementation shown in FIG. 1. Hereinafter, differences will be mainly described, and redundant descriptions may be omitted or briefly provided.

As illustrated in FIG. 2, the buffer layer 520 may be positioned between the second electrode 175 and the second conductivity type semiconductor layer 131. The buffer layer 520 may include a first surface 520a and a second surface 520b which is an opposite surface of the first surface 520a. The second conductivity type semiconductor layer 131 and the first conductivity type semiconductor layer 133 are positioned on the first surface 520a of the buffer layer 520, and the second electrode 175 may be positioned on the second surface 520b of the buffer layer 520.

The buffer layer 520 may include the first buffer layer 521 and the second buffer layer 522. The first buffer layer 521 may be positioned on the second buffer layer 522. The first buffer layer 521 may be positioned between the second buffer layer 522 and the second conductivity type semiconductor layer 131. The second buffer layer 522 may be positioned between the second electrode 175 and the first buffer layer 521.

With respect to the material of the first buffer layer 521 and its thickness in the third direction Z, the description regarding the material of the first buffer layer 511 of FIG. 1 and its thickness in the third direction Z may be equally applied. With respect to the material of the second buffer layer 522, the description regarding the material of the second buffer layer 512 of FIG. 1 may be equally applied.

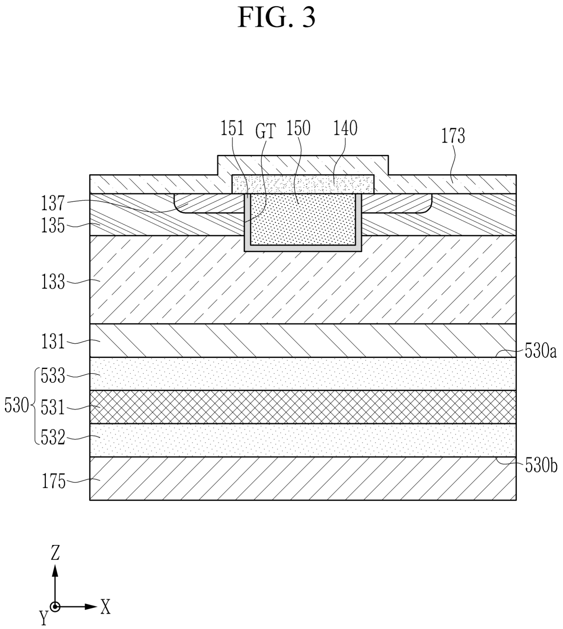

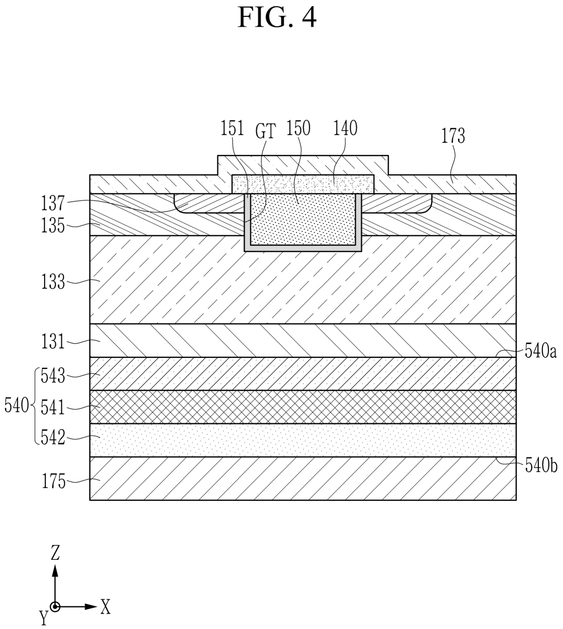

Hereinafter, with reference to FIG. 3 and FIG. 4, variations of the semiconductor device according to the implementation shown in FIG. 1 will be described.

FIG. 3 is a cross-sectional view of an example of a semiconductor device. FIG. 4 is a cross-sectional view of an example of a semiconductor device. In the implementation shown in FIG. 3, a buffer layer 530, a first buffer layer 531, and a second buffer layer 532 may correspond to the buffer layer 510, the first buffer layer 511, and the second buffer layer 512 of the implementation shown in FIG. 1. In the implementation shown in FIG. 4, a buffer layer 540, a first buffer layer 541, and a second buffer layer 542 may correspond to the buffer layer 510, the first buffer layer 511, and the second buffer layer 512 of the implementation shown in FIG. 1. In each implementation shown in FIG. 3 and FIG. 4, the same components as those of the implementation shown in FIG. 1 may be referenced by the same drawing reference numerals. In the implementation shown in FIG. 3, the buffer layer 530 further includes a third buffer layer 533, and in the implementation shown in FIG. 4, the buffer layer 540 further includes a third buffer layer 543, and thus may be partially different from the implementation shown in FIG. 1. Hereinafter, differences will be mainly described and redundant descriptions will be omitted or briefly mentioned.

As shown in FIG. 3, the buffer layer 530 may be positioned between the second electrode 175 and the second conductivity type semiconductor layer 131. The buffer layer 530 may include a first surface 530a and a second surface 530b opposite to the first surface 530a. The second conductivity type semiconductor layer 131 and the first conductivity type semiconductor layer 133 are positioned on the first surface 530a of the buffer layer 530, and the second electrode 175 may be positioned on the second surface 530b of the buffer layer 530.

The buffer layer 530 may include the first buffer layer 531, the second buffer layer 532, and the third buffer layer 533. The first buffer layer 531 may be positioned on the second buffer layer 532. The third buffer layer 533 may be positioned on the first buffer layer 531. The first buffer layer 531 may be positioned between the second buffer layer 532 and the third buffer layer 533. The second buffer layer 532 may be positioned between the second electrode 175 and the first buffer layer 531. The third buffer layer 533 may be positioned between the first buffer layer 531 and the second conductivity type semiconductor layer 131.

As for the material of the first buffer layer 531 and the thickness thereof in the third direction Z, the description regarding the material of the first buffer layer 511 of FIG. 1 and the thickness thereof in the third direction Z may be equally applied. As for the material of the second buffer layer 532, the description regarding the material of the second buffer layer 512 of FIG. 1 may be equally applied.

The content of the first element (X) in the third buffer layer 533 may be different from the content of the first element (X) in the first buffer layer 531. The content of the first element (X) in the third buffer layer 533 may be lower than the content of the first element (X) in the first buffer layer 531. For example, in the third buffer layer 533, the content of the first element (X) may be about 0 at% to about 1 at%. For example, the third buffer layer 533 may not include the first element (X). In another example, the third buffer layer 533 may include the first element (X), and the content of the first element (X) may be about 1 at% or less.

In some implementations, the content (at%) of the first element (X) in the third buffer layer 533 may be identical to the content (at%) of the first element (X) in the second buffer layer 532. For example, the second buffer layer 532 and the third buffer layer 533 may not include the first element (X). In another example, the second buffer layer 532 and the third buffer layer 533 may include the first element (X), and the content of the first element (X) may be n (0 < n ≤ 1) at%.

As shown in FIG. 4, the buffer layer 540 may be positioned between the second electrode 175 and the second conductivity type semiconductor layer 131. The buffer layer 540 may include a first surface 540a and a second surface 540b opposite to the first surface 540a. The second conductivity type semiconductor layer 131 and the first conductivity type semiconductor layer 133 are positioned on the first surface 540a of the buffer layer 540, and the second electrode 175 may be positioned on the second surface 540b of the buffer layer 540.

The buffer layer 540 may include the first buffer layer 541, the second buffer layer 542, and the third buffer layer 543. The first buffer layer 541 may be positioned on the second buffer layer 542. The third buffer layer 543 may be positioned on the first buffer layer 541. The first buffer layer 541 may be positioned between the second buffer layer 542 and the third buffer layer 543. The second buffer layer 542 may be positioned between the second electrode 175 and the first buffer layer 541. The third buffer layer 543 may be positioned between the first buffer layer 541 and the second conductivity type semiconductor layer 131.

With respect to the material and the thickness in the third direction Z of the first buffer layer 541, the description regarding the material and the thickness in the third direction Z of the first buffer layer 511 of FIG. 1 may be equally applied. With respect to the material of the second buffer layer 542, the description for the material of the second buffer layer 512 of FIG. 1 may be equally applied.

The content (at%) of the first element (X) in the third buffer layer 543 may be different from the content (at%) of the first element (X) in the first buffer layer 541. The content (at%) of the first element (X) in the third buffer layer 543 may be lower than the content (at%) of the first element (X) in the first buffer layer 541. For example, the content of the first element (X) in the third buffer layer 543 may be about 0 at% to about 1 at%. For example, the third buffer layer 543 may not include the first element (X). In another example, the third buffer layer 543 may include the first element (X), but the content of the first element (X) may be about 1 at% or less.

In some implementations, the content of the first element (X) in the third buffer layer 543 may be different from the content of the first element (X) in the second buffer layer 542. For example, in the third buffer layer 543, the content of the first element (X) may be higher than the content of the first element (X) in the second buffer layer 542. For example, the second buffer layer 542 may not include the first element X, and the third buffer layer 543 may include the first element X; however, in the third buffer layer 543, the content of the first element X may be about 1 at% or less. In another example, the second buffer layer 542 and the third buffer layer 543 each include the first element (X), and the content of the first element (X) in the second buffer layer 542 is s (0<s≤1) at%, and the content of the first element (X) in the third buffer layer 543 may be t (s<t≤1) at%. However, the implementation is not limited thereto. For example, the content (at%) of the first element (X) in the second buffer layer 542 may be higher than the content (at%) of the first element (X) in the third buffer layer 543.

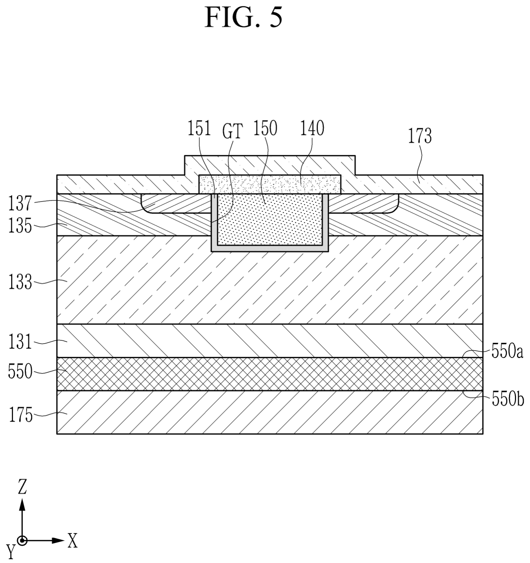

Hereinafter, with reference to FIG. 5, a variation of the semiconductor device according to the implementation shown in FIG. 1 will be described.

FIG. 5 is a cross-sectional view of an example of a semiconductor device. In the implementation shown in FIG. 5, a buffer layer 550 may correspond to the buffer layer 510 of the implementation shown in FIG. 1. In the implementation shown in FIG. 5, the components identical to the components of the implementation shown in FIG. 1 may be referred to by the same reference numerals. The implementation illustrated in FIG. 5 may differ in part from the implementation illustrated in FIG. 1 in that the entire buffer layer 550 includes a first element (X) homologous to Si, and the content of the first element (X) in the buffer layer 550 is about 10 at% to about 50 at%. Hereinafter, differences will be mainly described, and redundant descriptions may be omitted or briefly provided.

As shown in FIG. 5, the buffer layer 550 may be positioned between the second electrode 175 and the second conductivity type semiconductor layer 131. The buffer layer 550 may include a first surface 550a and a second surface 550b, which is an opposite surface of the first surface 550a. The second conductivity type semiconductor layer 131 and the first conductivity type semiconductor layer 133 are positioned on the first surface 550a of the buffer layer 550, and the second electrode 175 may be positioned on the second surface 550b of the buffer layer 550.

In the implementation illustrated in FIG. 1, the buffer layer 510 includes a first buffer layer 511 and a second buffer layer 512 having different contents of the first element (X), whereas, in the implementation illustrated in FIG. 5, the buffer layer 550 may be formed as a single layer including the first element (X). The content of the first element (X) in the buffer layer 550 may be identical to the content of the first element (X) in the first buffer layer 511. The content of the first element (X) in the buffer layer 550 may be about 10 at% to about 50 at%. The thickness of the buffer layer 550 in the third direction Z may be equal to the thickness of the first buffer layer 511 in the third direction Z. The thickness of the buffer layer 550 in the third direction Z may be greater than about 0 nm and not more than (e.g., less than or equal to) about 30 nm. The buffer layer 550 of the implementation shown in FIG. 5 may include only the first buffer layer 511 of the implementation shown in FIG. 1.

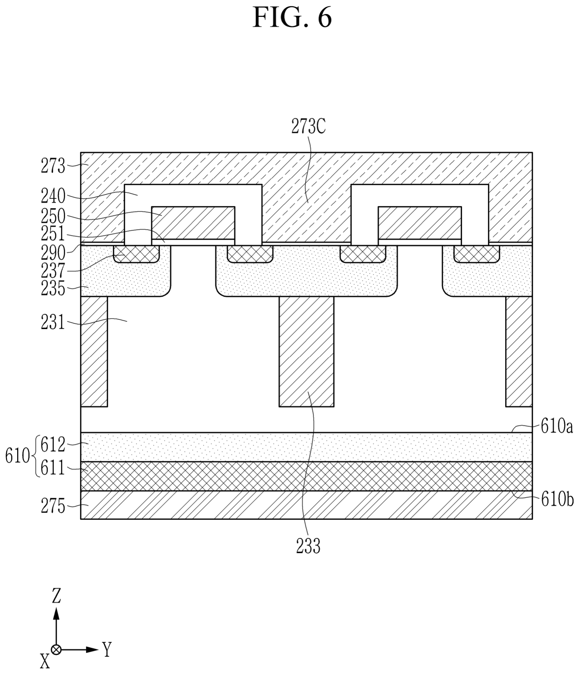

Hereinafter, a semiconductor device will be described with reference to FIG. 6.

FIG. 6 is a cross-sectional view of an example of a semiconductor device.

The semiconductor device may be a SiC semiconductor device. The semiconductor device may include at least one SiC-based semiconductor layer formed on a SiC substrate and at least one well region formed in the semiconductor layer, and may include a plurality of electrodes electrically connected to the semiconductor layer and the well region. The semiconductor device may not include a SiC substrate in the final structure, but at least one semiconductor layer and at least one well region may include SiC.

As shown in FIG. 6, a semiconductor device includes a buffer layer 610, a first conductivity type semiconductor layer 231 positioned on a first surface 610a of the buffer layer 610, a second conductivity type well region 235 positioned in the first conductivity type semiconductor layer 231, a first conductivity type well region 237 positioned in the second conductivity type well region 235, a gate electrode 250 adjacent to the second conductivity type well region 235, a first electrode 273 positioned on the first conductivity type well region 237, and a second electrode 275 positioned on a second surface 610b of the buffer layer 610, the second surface 610b being opposite to the first surface 610a.

The semiconductor device may include a second conductivity type pillar layer 233 (e.g., a pillar layer of the second conductivity type) between the buffer layer 610 and the second conductivity type well region 235.

According to an implementation, the semiconductor device does not include a substrate; however, the implementation is not limited thereto. For example, a substrate may be positioned between the buffer layer 610 and the second electrode 275. For example, the semiconductor device may include the buffer layer 610, the first conductivity type semiconductor layer 231, the second conductivity type pillar layer 233, the second conductivity type well region 235, the first conductivity type well region 237, the gate electrode 250, and the first electrode 273 on the first surface of the substrate, and may include the second electrode 275 on the second surface of the substrate, which is opposite to the first surface. In this case, the substrate may be a semiconductor substrate including SiC. For example, the substrate may be formed of a 4H SiC substrate. In some cases, the substrate may be formed of a 3C SiC substrate, a 6H SiC substrate, or the like. The substrate may have a first conductivity type. The substrate may be low-concentration doped in the first conductivity type. The first conductivity type may be n-type; however, it is not limited thereto. The resistivity of the substrate may be about 0.005 Ω·cm or more and about 0.035 Ω·cm or less. The thickness of the substrate may be about 10 µm or more and about 700 µm or less. The material, doping type, doping concentration, resistivity, thickness, and the like of the substrate are not limited thereto and may be variously changed. An implementation shown in FIG. 6 may be an example in which a substrate is removed from the final structure of a semiconductor device after being used in the manufacturing process.

The first conductivity type semiconductor layer 231, the second conductivity type pillar layer 233, the second conductivity type well region 235, and the first conductivity type well region 237 may include the same (e.g., an identical) semiconductor material. For example, the first conductivity type semiconductor layer 231 and the second conductivity type pillar layer 233 may be formed through an epitaxial growth process using the same (e.g., an identical) semiconductor material as a seed. For example, the second conductivity type well region 235 and the first conductivity type well region 237 may be formed by doping impurities (for example, ions) into the first conductivity type semiconductor layer 231 through an ion implantation process. The first conductivity type semiconductor layer 231, the second conductivity type pillar layer 233, the second conductivity type well region 235, and the first conductivity type well region 237 may include SiC.

The first conductivity type semiconductor layer 231, the second conductivity type pillar layer 233, the second conductivity type well region 235, and the first conductivity type well region 237 may include a semiconductor material doped with an impurity. The first conductivity type semiconductor layer 231 and the first conductivity type well region 237 may include a semiconductor material doped with an impurity of the first conductivity type. The second conductivity type pillar layer 233 and the second conductivity type well region 235 may include a semiconductor material doped with an impurity of the second conductivity type. The first conductivity type and the second conductivity type may be different. For example, the first conductivity type may be n-type, and the second conductivity type may be p-type.

The first conductivity type semiconductor layer 231 may be positioned on the first surface 610a of the buffer layer 610. The first conductivity type semiconductor layer 231 may surround the side surface and lower surface of the second conductivity type pillar layer 233. The first conductivity type semiconductor layer 231 may contact the side surface and lower surface of the second conductivity type pillar layer 233. The upper surface of the first conductivity type semiconductor layer 231 may be positioned at a higher level than the upper surface of the second conductivity type pillar layer 233.

The doping concentration of the first conductivity type semiconductor layer 231 may be about 1*10¹⁴ cm⁻³ or more and about 1*10¹⁷ cm⁻³ or less. The thickness of the first conductivity type semiconductor layer 231 in the third direction Z may be about 1 µm or more and about 13 µm or less. The third direction Z may be a direction perpendicular to the upper surface of the first conductivity type semiconductor layer 231. The doping concentration and the thickness in the third direction Z of the first conductivity type semiconductor layer 231 are not limited thereto and may be variously changed.

The second conductivity type pillar layer 233 may be surrounded by the first conductivity type semiconductor layer 231. The side surface and the lower surface of the second conductivity type pillar layer 233 may be surrounded by the first conductivity type semiconductor layer 231. The side surface and lower surface of the second conductivity type pillar layer 233 may contact the first conductivity type semiconductor layer 231. The second conductivity type pillar layer 233 may have a pillar shape extending in the third direction Z by penetrating the first conductivity type semiconductor layer 231. The second conductivity type pillar layer 233 may be positioned between the buffer layer 610 and the second conductivity type well region 235. The second conductivity type pillar layer 233 may be positioned between the second conductivity type well region 235 and the buffer layer 610. An upper surface of the second conductivity type pillar layer 233 may be connected to a lower surface of the second conductivity type well region 235. A lower surface of the second conductivity type pillar layer 233 may be positioned at a higher level than a lower surface of the first surface 610a of the buffer layer 610. The second conductivity type pillar layer 233 may be spaced apart from the buffer layer 610 by the first conductivity type semiconductor layer 231. The first conductivity type semiconductor layer 231 may be positioned between the second conductivity type pillar layer 233 and the buffer layer 610. The lower surface of the second conductivity type pillar layer 233 may be positioned at a higher level than the lower surface of the first conductivity type semiconductor layer 231.

The semiconductor device may include a plurality of second conductivity type pillar layers 233 spaced apart and arranged along the first direction X. The first conductivity type semiconductor layer 231 may be positioned between the plurality of second conductivity type pillar layers 233 spaced apart and arranged along the first direction X.

The second conductivity type well region 235 may extend from the upper surface of the first conductivity type semiconductor layer 231 toward the lower surface of the first conductivity type semiconductor layer 231, and may have a depth in the third direction Z. The upper surface of the second conductivity type well region 235 may be positioned at the same level as the upper surface of the first conductivity type semiconductor layer 231. A lower surface of the second conductivity type well region 235 may be positioned at a higher level than a lower surface of the first conductivity type semiconductor layer 231. The second conductivity type well region 235 may be positioned on the second conductivity type pillar layer 233. The lower surface of the second conductivity type well region 235 may be connected to the upper surface of the second conductivity type pillar layer 233, but is not limited thereto.

The doping concentration of the second conductivity type well region 235 may be about 1*10¹⁷ cm⁻³ or more and about 1*10¹⁹ cm⁻³ or less. The thickness of the second conductivity type well region 235 in the third direction Z may be about 0.3 µm or more and about 1.1 µm or less. The doping concentration and thickness of the second conductivity type well region 235 are not limited thereto and may be variously modified.

The semiconductor device may include a plurality of second conductivity type well regions 235 spaced apart and arranged along the first direction X. Each second conductivity type pillar layer 233 may be positioned between each second conductivity type well region 235 and buffer layer 610.

The length of the second conductivity type pillar layer 233 in the third direction Z may be longer than the thickness of the second conductivity type well region 235 in the third direction Z. The doping concentration of the second conductivity type pillar layer 233 may be lower than the doping concentration of the second conductivity type well region 235.

The first conductivity type well region 237 extends from an upper surface of the first conductivity type semiconductor layer 231 toward a lower surface of the first conductivity type semiconductor layer 231, and may have a depth in the third direction Z. The upper surface of the first conductivity type well region 237 may be positioned at the same level as the upper surface of the first conductivity type semiconductor layer 231. The lower surface of the first conductivity type well region 237 may be positioned at a higher level than the lower surface of the first conductivity type semiconductor layer 231.

The first conductivity type well region 237 may be positioned in the second conductivity type well region 235. The first conductivity type well region 237 extends from an upper surface of the first conductivity type semiconductor layer 231 toward a lower surface of the first conductivity type semiconductor layer 231, and may have a depth in the third direction Z. The depth (or thickness) in the third direction Z of the first conductivity type well region 237 may be less than the depth (or thickness) in the third direction Z of the second conductivity type well region 235. The upper surface of the first conductivity type well region 237 may be positioned at the same level as the upper surface of the second conductivity type well region 235. A lower surface of the first conductivity type well region 237 may be positioned at a higher level than a lower surface of the second conductivity type well region 235. The first conductivity type well region 237 may be surrounded by the second conductivity type well region 235. The lower surface and both side surfaces of the first conductivity type well region 237 may be surrounded by the second conductivity type well region 235.

The doping concentration of the first conductivity type well region 237 may be about 1*10¹⁷ cm⁻³ or more and about 5*10²⁰ cm⁻³ or less. The thickness of the first conductivity type well region 237 in the third direction Z may be about 0.1 µm or more and about 0.5 µm or less. The doping concentration and the thickness in the third direction Z of the first conductivity type well region 237 are not limited thereto and may be variously changed.

The semiconductor device may include a plurality of first conductivity type well regions 237 spaced apart and arranged in the first direction X. Two first conductivity type well regions 237 spaced apart in the first direction X may be positioned in the second conductivity type well region 235 (e.g., in the same second conductivity type well region 235), but the implementation is not limited thereto.

The gate electrode 250 and the gate insulating layer 251 may be positioned on the upper surface of the first conductivity type semiconductor layer 231, on the upper surface of the second conductivity type well region 235, and on the upper surface of the first conductivity type well region 237. The gate electrode 250 and the gate insulating layer 251 may be positioned on upper surfaces of two second conductivity type well regions 235 spaced apart in the first direction X on both sides of the first conductivity type semiconductor layer 231. The gate electrode 250 and the gate insulating layer 251 may be positioned on upper surfaces of two first conductivity type well regions 237 spaced apart in the first direction X and positioned on both sides of the first conductivity type semiconductor layer 231.

The gate electrode 250 may overlap in the third direction Z with the two second conductivity type well regions 235 and the two first conductivity type well regions 237, which are spaced apart in the first direction X and are positioned on both sides of the first conductivity type semiconductor layer 231 and the first conductivity type semiconductor layer 231.

The gate insulating layer 251 may be positioned between the gate electrode 250 and the first conductivity type semiconductor layer 231, between the gate electrode 250 and the second conductivity type well region 235, and between the gate electrode 250 and the first conductivity type well region 237. The gate electrode 250 may be spaced apart from the first conductivity type semiconductor layer 231, the second conductivity type well region 235, and the first conductivity type well region 237 by the gate insulating layer 251.

In the implementation shown in FIG. 6, as the gate electrode 150 and the gate insulating layer 251 are positioned on the upper surface of the first conductivity type semiconductor layer 231, the upper surface of the second conductivity type well region 235, and the upper surface of the first conductivity type well region 237, it overlaps the second conductivity type well region 235 and the first conductivity type well region 237 in the third direction Z, but the implementation is not limited thereto. For example, the gate electrode 250 may be positioned in a gate trench extending in the third direction Z from an upper surface of the first conductivity type semiconductor layer 231 toward a lower surface of the first conductivity type semiconductor layer 231. In this case, the gate electrode 250 may overlap the second conductivity type well region 235 and the first conductivity type well region 237 in the first direction X.

The gate electrode 250 may include a conductive material. For example, the gate electrode 250 may include polysilicon doped with an impurity, but is not limited thereto. In another example, the gate electrode 250 may include a metal, an alloy, a conductive metal nitride, a metal silicide, a semiconductor material doped with an impurity, a conductive metal oxide, a conductive metal oxynitride, or a combination thereof. The gate electrode 250 may be formed as a single layer or a multilayer.

The gate insulating layer 251 may include an insulating material. For example, the gate insulating layer 251 may include silicon oxide, but is not limited thereto. In another example, the gate insulating layer 251 may include silicon nitride, silicon oxynitride, silicon carbide, silicon carbonitride, or a combination thereof. The gate insulating layer 251 may be formed as a single layer or a multilayer.

The semiconductor device may include a protective layer 240 positioned on the gate insulating layer 251 and the gate electrode 250. The protective layer 240 may be positioned further on the first conductivity type well region 237. The protective layer 240 may cover the upper surface and side surfaces of the gate electrode 250, and the side surfaces of the gate insulating layer 251. The protective layer 140 may cover a portion of an upper surface of the first conductivity type well region 137.

The protective layer 240 may include an insulating material. For example, the protective layer 240 may include silicon oxide, silicon phosphide, silicon nitride, silicon oxynitride, or a combination thereof, but is not limited thereto. The protective layer 240 may be formed as a single layer or a multilayer.

In some implementations, the protective layer 240 may include the same material as (e.g., an identical material to) the gate insulating layer 251, but is not limited thereto. When the protective layer 240 includes the same material as (e.g., an identical material to) the gate insulating layer 251, the boundary between the protective layer 240 and the gate insulating layer 251 at the contacting portion between the protective layer 240 and the gate insulating layer 251 may not be clearly distinguished.

The first electrode 273 may be positioned on the first conductivity type well region 237. The first electrode 273 may be positioned further on the second conductivity type well region 235. The first electrode 273 may be positioned further on the protective layer 140. The first electrode 273 may overlap the gate electrode 250 in the third direction Z. The first electrode 273 may be spaced apart from the gate electrode 250 in the third direction Z and the first direction X by the protective layer 240.

The first electrode 273 may be electrically connected to the first conductivity type well region 237. The first electrode 273 may include a plurality of contact portions 273C. The plurality of contact portions 273C may be positioned between a plurality of gate electrodes 250 arranged spaced apart in the first direction X. The plurality of contact portions 273C may be connected to a plurality of first conductivity type well regions 237 arranged spaced apart in the first direction X. The contact portion 273C may be connected to the two first conductivity type well regions 237 arranged spaced apart in the first direction X within the second conductivity type well region 235, but is not limited thereto.

The first electrode 173 may also be electrically connected to the second conductivity type well region 135. The plurality of contact portions 273C may be connected to a plurality of second conductivity type well regions 235 spaced apart and arranged in the first direction X.

A silicide layer 290 may be positioned between the contact portion 273C and the first conductivity type well region 237, and between the contact portion 273C and the second conductivity type well region 235. The silicide layer 290 may cover the upper surface of the first conductivity type well region 237 and the upper surface of the second conductivity type well region 235. The upper surface of the silicide layer 290 may be in contact with the lower surface of the contact portion 273C. The contact resistance between the contact portion 273C and the first conductivity type well region 237, and between the contact portion 273C and the second conductivity type well region 235, may be reduced by the silicide layer 290.

The silicide layer 290 may include a metal silicide material. For example, the silicide layer 290 may include tungsten silicide (WSi), titanium silicide (TiSi), cobalt silicide (CoSi), nickel silicide (NiSi), or a combination thereof.

The second electrode 275 may be positioned on the second surface 610b of the buffer layer 610. The second electrode 275 may be electrically connected to the first conductivity type semiconductor layer 231 through the buffer layer 610.

The first electrode 273 and the second electrode 275 may include a conductive material. For example, the first electrode 273 and the second electrode 275 may include a metal, an alloy, a conductive metal nitride, a metal silicide, a semiconductor material doped with an impurity, a conductive metal oxide, a conductive metal oxynitride, or a combination thereof. The first electrode 273 and the second electrode 275 each may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAlN), tungsten nitride (WN), ruthenium (Ru), titanium aluminum (TiAl), titanium aluminum carbonitride (TiAIC-N), titanium aluminum carbide (TiAIC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. The first electrode 273 and the second electrode 275 may be formed as a single layer or a multilayer.

In some implementations, the second electrode 275 may include a material different from the first electrode 273, but is not limited thereto.

The semiconductor device may be a superjunction MOSFET. The first conductivity type semiconductor layer 231, the gate electrode 250, the gate insulating layer 251, and the first conductivity type well region 237 may constitute a MOSFET. The first conductivity type semiconductor layer 231 may be the drain region of a MOSFET. The second conductivity type well region 235 adjacent to the gate electrode 250 may be a channel region. When a channel is formed in the second conductivity type well region 235 by the voltage applied to the gate electrode 250, a current may flow between the first conductivity type well region 237 and the first conductivity type semiconductor layer 231. The semiconductor device may include the second conductivity type pillar layer 233 positioned between the second conductivity type well region 235 and the buffer layer 610, the second conductivity type pillar layer 233 extending in the third direction Z. The side surface and the lower surface of the second conductivity type pillar layer 233 may be in contact with the first conductivity type semiconductor layer 231. A depletion region may be formed along the interface where the first conductivity type semiconductor layer 231 and the second conductivity type pillar layer 233 having a different conductivity type contact each other, and the depletion region may be formed not only in the third direction Z, but also in the first direction X. That is, the semiconductor device may include the second conductivity type pillar layer 233, so that the depletion region is increased and the electric field may be distributed more widely, and the breakdown voltage may be increased. In the semiconductor device, the thickness of the first conductivity type semiconductor layer 231 may be thinner and the doping concentration may be higher than those of a semiconductor device according to a comparative example not including the second conductivity type pillar layer 233, and thus the on-resistance may be reduced. When the semiconductor device is a superjunction MOSFET, the first electrode 273 may be referred to as a source electrode, and the second electrode 275 may be referred to as a drain electrode.

The semiconductor device may include a buffer layer 610 between a SiC substrate and a semiconductor layer formed on the SiC substrate through an epitaxial growth process. The buffer layer 610 may serve to alleviate crystal defects propagated from the substrate. Accordingly, the electrical performance and reliability of the semiconductor device may be improved.

According to some implementations, when the SiC substrate is omitted in the final structure of the semiconductor device, the buffer layer 610 may be positioned between the second electrode 275 and the semiconductor layer. For example, when the semiconductor device includes a plurality of semiconductor layers formed by an epitaxial growth process, the buffer layer 610 may be positioned between the lowest semiconductor layer among the plurality of semiconductor layers and the second electrode 275.

The semiconductor device may include the first conductivity type semiconductor layer 231 and the second conductivity type pillar layer 233 formed on a SiC substrate through an epitaxial growth process. In this case, among the first conductivity type semiconductor layer 231 and the second conductivity type pillar layer 233, the first conductivity type semiconductor layer 231 may be the lowermost semiconductor layer. The buffer layer 610 of the semiconductor device may be positioned between the first conductivity type semiconductor layer 231, which is the lowermost semiconductor layer, and the second electrode 275.

The buffer layer 610 may include the first surface 610a and the second surface 610b opposite to the first surface 610a. On the first surface 610a of the buffer layer 610, the first conductivity type semiconductor layer 231 and the second conductivity type pillar layer 233 are positioned, and on the second surface 610b of the buffer layer 610, the second electrode 275 may be positioned.

The buffer layer 610 may include the same semiconductor material as the first conductivity type semiconductor layer 231 and the second conductivity type pillar layer 233. For example, the buffer layer 610 may be formed through an epitaxial growth process using the same semiconductor material as the seed as the first conductivity type semiconductor layer 231 and the second conductivity type pillar layer 233. The buffer layer 610 may include SiC.

The buffer layer 610 may include a semiconductor material doped with impurities. The buffer layer 610 may include a semiconductor material doped with an impurity of a first conductivity type. For example, the first conductivity type may be n-type.

The buffer layer 610 may include a first buffer layer 611 including a first element (X) homologous to Si. The first buffer layer 611 may include SiₚX_{q}C_{1-p-q}. The content of the first element (X) in the first buffer layer 611 may be about 10 at% to about 50 at%. That is, in the first buffer layer 611, the composition of SiₚX_{q}C_{1-p-q} may be such that p>0 and 0.1≤q≤0.5.

For example, the first element (X) may be Ge. When the first element (X) is Ge, the first buffer layer 611 may include SiₚGe_{q}C_{1-p-q}. The composition of SiₚGe_{q}C_{1-p-q} within the first buffer layer 611 may be such that p>0 and 0.1≤q≤0.5. However, the implementations are not limited thereto, and the first element (X) may be variously changed.

For example, the first element (X) may be C. In this case, the first buffer layer 611 may include SiCₘ, and m may be greater than 1. That is, within the first buffer layer 611, the content (at%) of C may be higher than the content (at%) of Si.

The thickness of the first buffer layer 611 in the third direction Z may be greater than about 0 nm and less than or equal to about 30 nm. When the thickness of the first buffer layer 611 in the third direction Z is greater than about 0 nm and less than or equal to about 30 nm, the distance over which defects in the first buffer layer 611 are propagated may be shortened, thereby reducing the defect density reaching the upper layer of the first buffer layer 611.

In some implementations, the buffer layer 610 may further include a second buffer layer 612. The second buffer layer 612 may be positioned on the first buffer layer 611. The second buffer layer 612 may be positioned between the first buffer layer 611 and the first conductivity type semiconductor layer 231. The content of the first element (X) in the second buffer layer 612 may be different from the content of the first element (X) in the first buffer layer 611. The content of the first element (X) in the second buffer layer 612 may be lower than the content of the first element (X) in the first buffer layer 611. For example, in the second buffer layer 612, the content of the first element (X) may be about 0 at% to about 1 at%. The second buffer layer 612 may include SiₚX_{q}C_{1-p-q}, where p > 0 and 0 ≤ q ≤ 1. For example, the second buffer layer 612 may not include the first element (X). In this case, the second buffer layer 612 may include SiC. In another example, the second buffer layer 612 may include the first element (X), and the content of the first element (X) may be approximately 1 at% or less. In this case, the second buffer layer 612 may include SiₚX_{q}C_{1-p-q}, where p>0 and 0<q≤1.

The buffer layer 610 of the semiconductor device includes the first buffer layer 611 including a first element homologous to Si, and as the content of the first element in the first buffer layer 611 is about 10 at% to about 50 at%, it may be possible to prevent threading dislocations from propagating through the semiconductor layer (for example, the first conductivity type semiconductor layer 231 and/or the second conductivity type pillar layer 233) positioned on the buffer layer 610.

The buffer layer 610 of the semiconductor device includes the second buffer layer 612 including a first element homologous to Si, and the content of the first element within the second buffer layer 612 is about 1 at% or less, so that the film quality of the semiconductor layer (for example, the first conductivity type semiconductor layer 231 and/or the second conductivity type pillar layer 233) positioned on the buffer layer 610 may be improved.

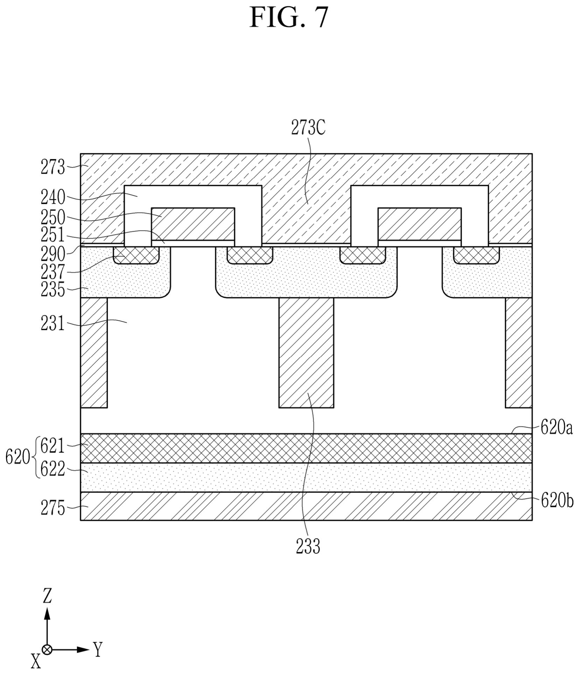

Hereinafter, with reference to FIG. 7, a modification of the semiconductor device according to the implementation illustrated in FIG. 6 will be described.

FIG. 7 is a cross-sectional view of an example of a semiconductor device. In the implementation shown in FIG. 7, a buffer layer 620, a first buffer layer 621, and a second buffer layer 622 may correspond to the buffer layer 610, the first buffer layer 611, and the second buffer layer 612 of the implementation shown in FIG. 6. In the implementation shown in FIG. 7, the components identical to the components of the implementation shown in FIG. 6 may be referred to by identical reference numerals in the drawing. The implementation shown in FIG. 7 may have a positional relationship between the first buffer layer 621 and the second buffer layer 622 that is partially different from the implementation shown in FIG. 6. Hereinafter, differences will be mainly described, and repeated descriptions are omitted or briefly given.

As shown in FIG. 7, the buffer layer 620 may be positioned between the second electrode 275 and the first conductivity type semiconductor layer 231. The buffer layer 620 may include a first surface 620a and a second surface 620b opposite to the first surface 620a. On the first surface 620a of the buffer layer 620, the first conductivity type semiconductor layer 231 and the second conductivity type pillar layer 233 are positioned, and on the second surface 620b of the buffer layer 620, the second electrode 275 may be positioned.

The buffer layer 620 may include the first buffer layer 621 and the second buffer layer 622. The first buffer layer 621 may be positioned on the second buffer layer 622. The first buffer layer 621 may be positioned between the second buffer layer 622 and the first conductivity type semiconductor layer 231. The second buffer layer 622 may be positioned between the second electrode 275 and the first buffer layer 621.

With respect to the material of the first buffer layer 621 and the thickness thereof in the third direction Z, the description regarding the material of the first buffer layer 611 of FIG. 6 and the thickness thereof in the third direction Z may be equally applied. With respect to the material of the second buffer layer 622, the description of the material of the second buffer layer 612 of FIG. 6 may be equally applied.

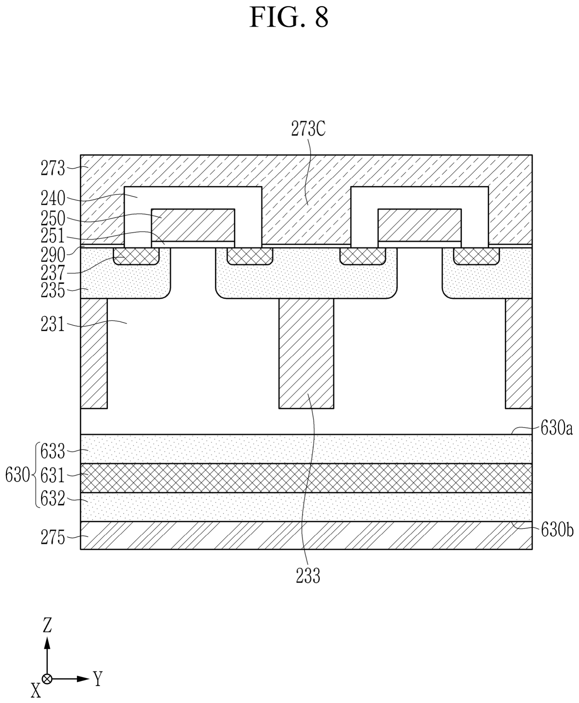

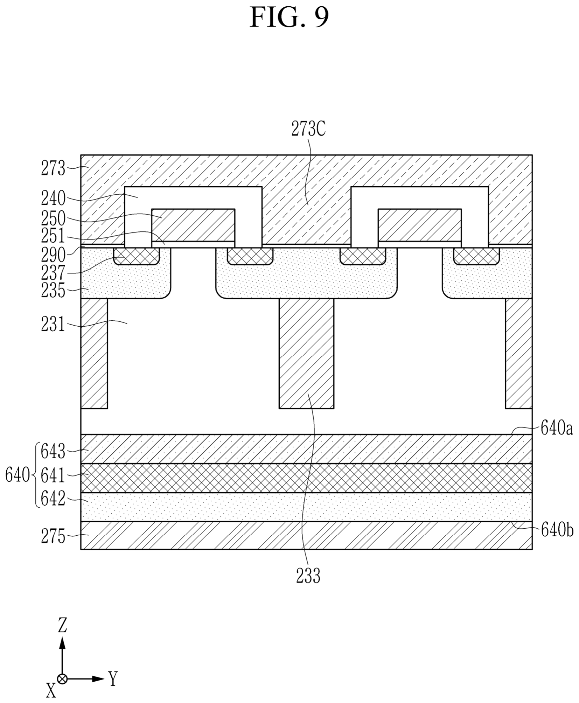

Hereinafter, with reference to FIG. 8 and FIG. 9, variations of the semiconductor device according to the implementation illustrated in FIG. 6 will be described.

FIG. 8 is a cross-sectional view of an example of a semiconductor device. FIG. 9 is a cross-sectional view of an example of a semiconductor device. In the implementation shown in FIG. 8, a buffer layer 630, a first buffer layer 631, and a second buffer layer 632 may correspond to the buffer layer 610, the first buffer layer 611, and the second buffer layer 612 of the implementation shown in FIG. 6. In the implementation shown in FIG. 9, a buffer layer 640, a first buffer layer 641, and a second buffer layer 642 may correspond to the buffer layer 610, the first buffer layer 611, and the second buffer layer 612 of the implementation shown in FIG. 6. In each implementation shown in FIG. 8 and FIG. 9, components identical to the components of the implementation shown in FIG. 6 may be referenced by identical drawing reference numerals. In the implementation shown in FIG. 8, the buffer layer 630 further includes a third buffer layer 633, and in the implementation shown in FIG. 9, the buffer layer 640 further includes a third buffer layer 643, and thus may differ in part from the implementation shown in FIG. 6. Hereinafter, differences will be mainly described, and overlapping descriptions will be omitted or briefly stated.

As shown in FIG. 8, the buffer layer 630 may be positioned between the second electrode 275 and the first conductivity type semiconductor layer 231. The buffer layer 630 may include a first surface 630a and a second surface 630b opposite to the first surface 630a. On the first surface 630a of the buffer layer 630, the first conductivity type semiconductor layer 231 and the second conductivity type pillar layer 233 are positioned, and on the second surface 630b of the buffer layer 630, the second electrode 175 may be positioned.

The buffer layer 630 may include the first buffer layer 631, the second buffer layer 632, and the third buffer layer 633. The first buffer layer 631 may be positioned on the second buffer layer 632. The third buffer layer 633 may be positioned on the first buffer layer 631. The first buffer layer 631 may be positioned between the second buffer layer 632 and the third buffer layer 633. The second buffer layer 632 may be positioned between the second electrode 275 and the first buffer layer 631. The third buffer layer 633 may be positioned between the first buffer layer 631 and the first conductivity type semiconductor layer 231.

With respect to the material of the first buffer layer 631 and the thickness in the third direction Z, the description regarding the material of the first buffer layer 611 of FIG. 6 and the thickness in the third direction Z may be equally applied. With respect to the material of the second buffer layer 632, the description of the material of the second buffer layer 612 of FIG. 1 may be equally applied.

The content of the first element (X) in the third buffer layer 633 may be different from the content of the first element (X) in the first buffer layer 631. The content of the first element (X) within the third buffer layer 633 may be lower than the content of the first element (X) within the first buffer layer 631. For example, in the third buffer layer 633, a content of the first element (X) may be about 0 at% to about 1 at%. For example, the third buffer layer 633 may not include the first element (X). In another example, the third buffer layer 633 may include the first element (X), and the content of the first element (X) may be about 1 at% or less.

In some implementations, the content (at%) of the first element (X) in the third buffer layer 633 may be identical to the content (at%) of the first element (X) in the second buffer layer 632. For example, the second buffer layer 632 and the third buffer layer 633 may not include the first element (X). In another example, the second buffer layer 632 and the third buffer layer 633 may include the first element (X), and the content of the first element (X) may be n (0<n≤1) at%.

As shown in FIG. 9, a buffer layer 640 may be positioned between the second electrode 275 and the first conductivity type semiconductor layer 231. The buffer layer 640 may include a first surface 640a and a second surface 640b opposite to the first surface 640a. On the first surface 640a of the buffer layer 640, the first conductivity type semiconductor layer 231 and the second conductivity type pillar layer 233 are positioned, and on the second surface 640b of the buffer layer 640, the second electrode 275 may be positioned.

The buffer layer 640 may include the first buffer layer 641, the second buffer layer 642, and the third buffer layer 643. The first buffer layer 641 may be positioned on the second buffer layer 642. The third buffer layer 643 may be positioned on the first buffer layer 641. The first buffer layer 641 may be positioned between the second buffer layer 642 and the third buffer layer 643. The second buffer layer 642 may be positioned between the second electrode 275 and the first buffer layer 641. The third buffer layer 643 may be positioned between the first buffer layer 641 and the first conductivity type semiconductor layer 231.

With respect to the material of the first buffer layer 641 and the thickness in the third direction Z, the description regarding the material of the first buffer layer 611 of FIG. 6 and the thickness in the third direction Z may be equally applied. As for the material of the second buffer layer 642, the description regarding the material of the second buffer layer 612 of FIG. 6 may be equally applied.

The content (at%) of the first element (X) in the third buffer layer 643 may be different from the content (at%) of the first element (X) in the first buffer layer 641. The content (at%) of the first element (X) within the third buffer layer 643 may be lower than the content (at%) of the first element (X) within the first buffer layer 641. For example, in the third buffer layer 643, the content of the first element (X) may be about 0 at% to about 1 at%. For example, the third buffer layer 643 may not include the first element (X). In another example, the third buffer layer 643 includes the first element (X), and the content of the first element (X) may be about 1 at% or less.

In some implementations, the content of the first element (X) in the third buffer layer 643 may be different from the content of the first element (X) in the second buffer layer 642. For example, the content of the first element (X) in the third buffer layer 643 may be higher than the content of the first element (X) in the second buffer layer 642. For example, the second buffer layer 642 does not include the first element (X), and the third buffer layer 643 includes the first element (X), but the content of the first element (X) in the third buffer layer 643 may be about 1 at% or less. In another example, the second buffer layer 642 and the third buffer layer 643 each include the first element (X), the content of the first element (X) in the second buffer layer 642 may be s (0 < s ≤ 1) at%, and the content of the first element (X) in the third buffer layer 643 may be t (s < t ≤ 1) at%. However, the implementations are not limited thereto. For example, the content (at%) of the first element (X) in the second buffer layer 642 may be higher than the content (at%) of the first element (X) in the third buffer layer 643.

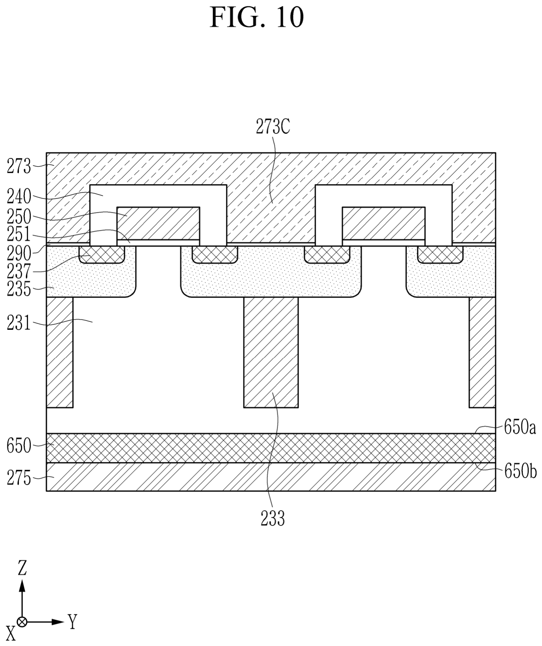

Hereinafter, with reference to FIG. 10, modifications of the semiconductor device according to the implementation shown in FIG. 6 will be described.

FIG. 10 is a cross-sectional view of an example of a semiconductor device. In the implementation shown in FIG. 10, a buffer layer 650 may correspond to the buffer layer 610 of the implementation shown in FIG. 6. In the implementation shown in FIG. 10, components identical to the components of the implementation shown in FIG. 6 may be referenced by identical drawing reference numerals. The implementation shown in FIG. 10 may differ in part from the implementation shown in FIG. 6 in that the entire buffer layer 650 includes a first element (X) homologous to Si, and the content of the first element (X) in the buffer layer 650 is about 10 at% to about 50 at%. Hereinafter, the differences will be mainly described and redundant descriptions will be omitted or briefly provided.

As shown in FIG. 10, the buffer layer 650 may be positioned between the second electrode 275 and the first conductivity type semiconductor layer 231. The buffer layer 650 may include a first surface 650a and a second surface 650b which is opposite to the first surface 650a. On the first surface 650a of the buffer layer 650, the first conductivity type semiconductor layer 231 and the second conductivity type pillar layer 233 are positioned, and on the second surface 650b of the buffer layer 650, the second electrode 275 may be positioned.

In the implementation shown in FIG. 6, the buffer layer 610 includes a first buffer layer 611 and a second buffer layer 612 having different contents of the first element (X), whereas in the implementation shown in FIG. 10, the buffer layer 650 may be formed as a single layer including the first element (X). The content of the first element (X) in the buffer layer 650 may be the same as the content of the first element (X) in the first buffer layer 611. The content of the first element (X) in the buffer layer 650 may be about 10 at% to about 50 at%. The thickness of the buffer layer 650 in the third direction Z may be identical to the thickness of the first buffer layer 611 in the third direction Z. The thickness of the buffer layer 650 in the third direction Z may be more than about 0 nm and not more than about 30 nm. The buffer layer 650 of the implementation shown in FIG. 10 may include only the first buffer layer 611 of the implementation shown in FIG. 6.

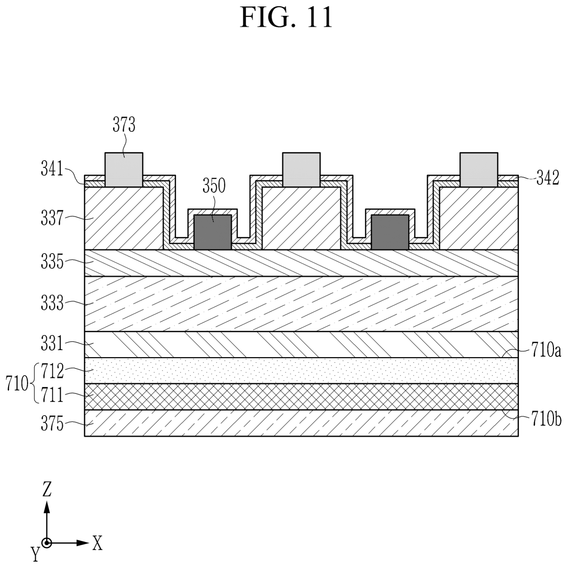

Hereinafter, a semiconductor device will be described with reference to FIG. 11.

FIG. 11 is a cross-sectional view of an example of a semiconductor device.

The semiconductor device may be a SiC semiconductor device. The semiconductor device may include at least one SiC-based semiconductor layer formed on a SiC substrate, and at least one well region formed in the semiconductor layer, and may include a plurality of electrodes electrically connected to the semiconductor layer and the well region. The semiconductor device may not include a SiC substrate in the final structure; however, at least one semiconductor layer and at least one well region may include SiC.

As shown in FIG. 11, a semiconductor device includes a buffer layer 710, a first conductivity type first semiconductor layer 331, a second conductivity type second semiconductor layer 333, a first conductivity type third semiconductor layer 335, a second conductivity type fourth semiconductor layer 337 sequentially stacked on a first surface 710a of the buffer layer 710, a gate electrode 350 positioned on an upper surface of the second semiconductor layer 333 or the third semiconductor layer 335, a first electrode 373 positioned on an upper surface of the fourth semiconductor layer 337, and a second electrode 375 positioned on a second surface 710b of the buffer layer 710, which is opposite to the first surface 710a.

The semiconductor device does not include a substrate, but the implementation is not limited thereto. For example, a substrate may be positioned between the buffer layer 710 and the second electrode 375. For example, the semiconductor device may include the buffer layer 710, the first semiconductor layer 331, the second semiconductor layer 333, the third semiconductor layer 335, the fourth semiconductor layer 337, the gate electrode 350, and the first electrode 373 on the first surface of the substrate, and may include the second electrode 375 on the second surface of the substrate, which is an opposite surface to the first surface. In this case, the substrate may be a semiconductor substrate including SiC. For example, the substrate may be formed of a 4H SiC substrate. In some cases, the substrate may be formed of a 3C SiC substrate, a 6H SiC substrate, or the like. The substrate may have a first conductivity type. The substrate may be doped with a low concentration as the first conductivity type. The first conductivity type may be an n-type, but is not limited thereto. The resistivity of the substrate may be about 0.005 Ωcm or more and about 0.035 Ωcm or less. The thickness of the substrate may be about 10 µm or more and about 700 µm or less. The material, doping type, doping concentration, resistivity, thickness, and the like of the substrate are not limited thereto and may be variously modified. The implementation shown in FIG. 11 may be an example in which the substrate is removed from the final structure of the semiconductor device after the substrate is used in the manufacturing process.

The first semiconductor layer 331, the second semiconductor layer 333, the third semiconductor layer 335, and the fourth semiconductor layer 337 may include the same (e.g., an identical) semiconductor material. For example, the first semiconductor layer 331, the second semiconductor layer 333, the third semiconductor layer 335, and the fourth semiconductor layer 337 may be formed through an epitaxial growth process using the same (e.g., an identical) semiconductor material as a seed. The first semiconductor layer 331, the second semiconductor layer 333, the third semiconductor layer 335, and the fourth semiconductor layer 337 may include SiC.

The first semiconductor layer 331, the second semiconductor layer 333, the third semiconductor layer 335, and the fourth semiconductor layer 337 may include a semiconductor material doped with impurities. The first semiconductor layer 331 and the third semiconductor layer 335 may include a semiconductor material doped with an impurity of the first conductivity type. The second semiconductor layer 333 and the fourth semiconductor layer 337 may include a semiconductor material doped with an impurity of the second conductivity type. The first conductivity type and the second conductivity type may be different from each other. For example, the first conductivity type may be n-type, and the second conductivity type may be p-type.

The first semiconductor layer 331 may be positioned on the first surface 710a of the buffer layer 710. The doping concentration of the first semiconductor layer 331 may be lower than the doping concentration of the substrate. The doping concentration of the first semiconductor layer 331 may be higher than the doping concentration of the third semiconductor layer 335. The doping concentration of the first semiconductor layer 331 may be about 1*10¹⁷ cm⁻³ or more and about 5*10¹⁹ cm⁻³ or less. The doping concentration of the first semiconductor layer 331 is not limited thereto and may be variously changed.

The second semiconductor layer 333 may be positioned on the upper surface of the first semiconductor layer 331. The doping concentration of the second semiconductor layer 333 may be lower than the doping concentration of the fourth semiconductor layer 337. The doping concentration of the second semiconductor layer 333 may be about 1*10¹⁴cm⁻³ or more and about 1*10¹⁷cm⁻³ or less. The thickness of the second semiconductor layer 333 in a third direction Z may be about 1 µm or more and about 13 µm or less. The doping concentration and thickness of the second semiconductor layer 333 are not limited thereto and may be variously changed.

The third semiconductor layer 335 may be positioned on the upper surface of the second semiconductor layer 333. The doping concentration of the third semiconductor layer 335 may be lower than the doping concentration of the first semiconductor layer 331. The doping concentration of the third semiconductor layer 335 may be about 1*10¹⁴ cm⁻³ or more and about 1*10¹⁹ cm⁻³ or less. The thickness of the third semiconductor layer 335 in the third direction Z may be about 0.3 µm or more and about 1.1 µm or less. The doping concentration and thickness of the third semiconductor layer 335 are not limited thereto and may be variously changed.

The fourth semiconductor layer 337 may be positioned on the upper surface of the third semiconductor layer 335. The fourth semiconductor layer 337 may have a doping concentration higher than that of the second semiconductor layer 333. The doping concentration of the fourth semiconductor layer 337 may be about 1*10¹⁷ cm⁻³ or more and about 5*10²⁰ cm⁻³ or less. The doping concentration of the fourth semiconductor layer 337 is not limited thereto and may be variously changed.

The semiconductor device may include a plurality of fourth semiconductor layers 337 arranged spaced apart in the first direction X. The first direction X may be a direction parallel to an upper surface of the third semiconductor layer 335.

In some implementations, the gate electrode 350 may be positioned on the upper surface of the third semiconductor layer 335. The gate electrode 350 may be electrically connected to the third semiconductor layer 335. For example, the gate electrode 350 may be in contact with an upper surface of the third semiconductor layer 335, but is not limited thereto. Another layer may be positioned between the gate electrode 350 and the third semiconductor layer 335.

The gate electrode 350 may be positioned between two fourth semiconductor layers 337 spaced apart in the first direction X. The gate electrode 350 may be spaced apart from a side surface of the fourth semiconductor layer 337 in the first direction X.

The semiconductor device may include a plurality of gate electrodes 350 arranged spaced apart in the first direction X. A plurality of gate electrodes 350 and a plurality of fourth semiconductor layers 337 may be alternately and repeatedly arranged along the first direction X on the upper surface of the third semiconductor layer 335.

In the implementation shown in FIG. 11, the gate electrode 350 is positioned on the upper surface of the third semiconductor layer 335 and is electrically connected with the third semiconductor layer 335, but the implementation is not limited thereto. For example, the gate electrode 350 may be positioned on the upper surface of the second semiconductor layer 333 and may be electrically connected to the second semiconductor layer 333. In this case, the semiconductor device may include a plurality of fourth semiconductor layers 337 and a plurality of third semiconductor layers 335 that are spaced apart and arranged in the first direction X, and the gate electrode 350 may be positioned between two fourth semiconductor layers 337 spaced apart in the first direction X and two third semiconductor layers 335 spaced apart in the first direction X. For example, the gate electrode 350 may be in contact with an upper surface of the second semiconductor layer 333, but is not limited thereto. Another layer may be positioned between the gate electrode 350 and the second semiconductor layer 333.

The first electrode 373 may be positioned on the upper surface of the fourth semiconductor layer 337. The first electrode 373 may be electrically connected to the fourth semiconductor layer 337. For example, the first electrode 373 may be in contact with an upper surface of the fourth semiconductor layer 337, but is not limited thereto. Another layer may be positioned between the first electrode 373 and the fourth semiconductor layer 337.

The semiconductor device may include a plurality of first electrodes 373 arranged spaced apart in the first direction X. Each first electrode 373 may be positioned on each fourth semiconductor layer 337.

The first electrode 373 and the gate electrode 350 may include a conductive material. For example, the first electrode 373 and the gate electrode 350 each may include a metal, an alloy, a conductive metal nitride, a metal silicide, a doped semiconductor material, a conductive metal oxide, a conductive metal oxynitride, or a combination thereof. The first electrode 373 and the gate electrode 350 each may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbonitride (TiAIC-N), titanium aluminum carbide (TiAIC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. The first electrode 373 and the gate electrode 350 each may be formed of a single layer or a plurality of layers.

In some implementations, the first electrode 373 and the gate electrode 350 may include different materials, but is not limited thereto.

The semiconductor device may include a first protective layer 341 and a second protective layer 342. The first protective layer 341 may be positioned on the third semiconductor layer 335 and the fourth semiconductor layer 337. The first protective layer 341 may cover the upper surface of the third semiconductor layer 335 and the upper surface of the fourth semiconductor layer 337. The first protective layer 341 may cover a portion of a side surface of the gate electrode 350 on the third semiconductor layer 335. The first protective layer 341 may cover a portion of a side surface of the first electrode 373 over the fourth semiconductor layer 337. The second protective layer 342 may be positioned on the first protective layer 341 and the gate electrode 350. The second protective layer 342 may cover the upper surface and side surface of the first protective layer 341. The second protective layer 342 may cover the upper surface and side surface of the gate electrode 350. The second protective layer 342 may cover the remaining portion of the side surface of the gate electrode 350 that is not covered by the first protective layer 341.

The first protective layer 341 and the second protective layer 342 may include an insulating material. For example, the first protective layer 341 and the second protective layer 342 may each include silicon oxide, silicon phosphide, silicon nitride, silicon oxynitride, or a combination thereof, but are not limited thereto.

The second electrode 375 may be positioned on the second surface 710b of the buffer layer 710. The second electrode 375 may be electrically connected to the first semiconductor layer 331 through the buffer layer 710. The second electrode 375 may include a conductive material. For example, the second electrode 375 may include a metal, an alloy, a conductive metal nitride, a metal silicide, a doped semiconductor material, a conductive metal oxide, a conductive metal oxynitride, or a combination thereof. The second electrode may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbonitride (TiAIC-N), titanium aluminum carbide (TiAIC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or combinations thereof, but is not limited thereto. The second electrode 375 may be formed as a single layer or a multilayer.

In some implementations, the first electrode 373 and the second electrode 375 may include different materials, but is not limited thereto.

The semiconductor device may be a thyristor. For example, the semiconductor device may be a gate turn-off thyristor in which a PNP transistor and an NPN transistor are combined and that may be turned on/off through a gate electrode. The second semiconductor layer 333, the third semiconductor layer 335, and the fourth semiconductor layer 337 may form a PNP transistor. The third semiconductor layer 335 may be the base region of the PNP transistor. The first semiconductor layer 331, the second semiconductor layer 333, and the third semiconductor layer 335 may constitute an NPN transistor. The second semiconductor layer 333 may be the base region of the NPN transistor. The gate electrode 350 may be electrically connected to the third semiconductor layer 335, but is not limited thereto. For example, the gate electrode 350 may be electrically connected to the second semiconductor layer 333. A current may flow between the fourth semiconductor layer 337 and the first semiconductor layer 331 by a voltage applied to the gate electrode 350. When the semiconductor device is a thyristor, the first electrode 373 may be referred to as an anode electrode, and the second electrode 375 may be referred to as a cathode electrode.

The semiconductor device may include a buffer layer 710 between a SiC substrate and a semiconductor layer formed on the SiC substrate through an epitaxial growth process. The buffer layer 710 may serve to mitigate crystal defects propagated from the substrate. Accordingly, the electrical performance and reliability of the semiconductor device may be improved.

According to some implementations, when the SiC substrate is omitted in the final structure of the semiconductor device, the buffer layer 710 may be positioned between the second electrode 375 and the semiconductor layer. For example, in a case where the semiconductor device includes a plurality of semiconductor layers formed by an epitaxial growth process, the buffer layer 710 may be positioned between the lowermost semiconductor layer among the plurality of semiconductor layers and the second electrode 375.

The semiconductor device may include the first semiconductor layer 331, the second semiconductor layer 333, the third semiconductor layer 335, and the fourth semiconductor layer 337 formed on a SiC substrate through an epitaxial growth process. In this case, among the first semiconductor layer 331, the second semiconductor layer 333, the third semiconductor layer 335, and the fourth semiconductor layer 337, the first semiconductor layer 331 may be the lowest semiconductor layer. The buffer layer 710 of the semiconductor device may be positioned between the first semiconductor layer 331, which is the lowermost semiconductor layer, and the second electrode 375.

The buffer layer 710 may include the first surface 710a and the second surface 710b opposite to the first surface 710a. The first semiconductor layer 331, the second semiconductor layer 333, the third semiconductor layer 335, and the fourth semiconductor layer 337 are positioned on the first surface 710a of the buffer layer 710, and the second electrode 375 may be positioned on the second surface 710b of the buffer layer 710.

The buffer layer 710 may include the same semiconductor material as the first semiconductor layer 331, the second semiconductor layer 333, the third semiconductor layer 335, and the fourth semiconductor layer 337. For example, the buffer layer 710 may be formed through an epitaxial growth process using the identical semiconductor material as a seed for the first semiconductor layer 331, the second semiconductor layer 333, the third semiconductor layer 335, and the fourth semiconductor layer 337. The buffer layer 710 may include SiC.

The buffer layer 710 may include a semiconductor material doped with impurities. The buffer layer 710 may include a semiconductor material doped with an impurity of the first conductivity type. For example, the first conductivity type may be n-type.

The buffer layer 710 may include a first buffer layer 711 including a first element (X) homologous to Si. The first buffer layer 711 may include SiₚX_{q}C_{1-p-q}. The content of the first element (X) in the first buffer layer 711 may be about 10 at% to about 50 at%. That is, in the first buffer layer 711, the composition of SiₚX_{q}C_{1-p-q} may be p>0 and 0.1≤q≤0.5.

For example, the first element (X) may be Ge. When the first element (X) is Ge, the first buffer layer 711 may include SiₚGe_{q}C_{1-p-q}. The composition of SiₚGe_{q}C_{1-p-q} in the first buffer layer 711 may have p>0 and 0.1≤q≤0.5. However, the implementation is not limited thereto, and the first element (X) may be variously changed.

For example, the first element (X) may be C. In this case, the first buffer layer 711 may include SiCₘ, and m may be greater than 1. That is, within the first buffer layer 711, the content (at%) of C may be higher than the content (at%) of Si.

The thickness of the first buffer layer 711 in the third direction Z may be greater than about 0 nm and not more than about 30 nm. When the thickness of the first buffer layer 711 in the third direction Z is greater than about 0 nm and not more than about 30 nm, the propagation distance of defects in the first buffer layer 711 may be shortened, thereby reducing the defect density reaching the upper layer of the first buffer layer 711.

In some implementations, the buffer layer 710 may further include a second buffer layer 712. The second buffer layer 712 may be positioned on the first buffer layer 711. The second buffer layer 712 may be positioned between the first buffer layer 711 and the first semiconductor layer 331. The content of the first element (X) in the second buffer layer 712 may be different from the content of the first element (X) in the first buffer layer 711. The content of the first element (X) in the second buffer layer 712 may be lower than the content of the first element (X) in the first buffer layer 711. For example, in the second buffer layer 712, the content of the first element (X) may be about 0 at% to about 1 at%. The second buffer layer 712 may include SiₚX_{q}C_{1-p-q}, where p > 0, and 0 ≤ q ≤ 1. For example, the second buffer layer 712 may not include the first element (X). In this case, the second buffer layer 712 may include SiC. In another example, the second buffer layer 712 includes the first element (X), but the content of the first element (X) may be about 1 at% or less. In this case, the second buffer layer 712 may include SiₚX_{q}C_{1-p-q}, where p>0 and 0<q≤1.

The buffer layer 710 of the semiconductor device includes the first buffer layer 711 including a first element homologous to Si, and when the content of the first element in the first buffer layer 711 is about 10 at% to about 50 at%, it may be possible to prevent threading dislocations propagating through the semiconductor layer positioned on the buffer layer 710 (for example, the first semiconductor layer 331, the second semiconductor layer 333, the third semiconductor layer 335, and/or the fourth semiconductor layer 337).

The buffer layer 710 of the semiconductor device includes the second buffer layer 712 including a first element homologous to Si, and, since the content of the first element in the second buffer layer 712 is about 1 at% or less, the film quality of a semiconductor layer (e.g., a first semiconductor layer 331, a second semiconductor layer 333, a third semiconductor layer 335, and/or a fourth semiconductor layer 337) positioned on the buffer layer 710 may be improved.

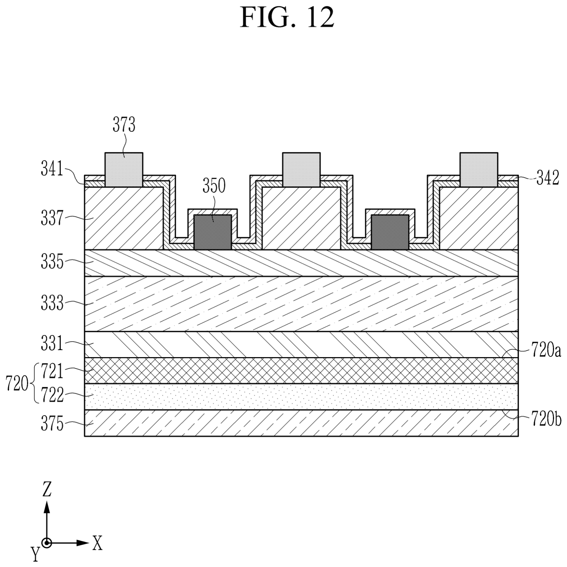

Hereinafter, a modified example of the semiconductor device according to the implementation shown in FIG. 11 will be described with reference to FIG. 12.

FIG. 12 is a cross-sectional view of an example of a semiconductor device. In the implementation shown in FIG. 12, a buffer layer 720, a first buffer layer 721, and a second buffer layer 722 may correspond to the buffer layer 710, first buffer layer 711, and second buffer layer 712 of the implementation shown in FIG. 11. In the implementation illustrated in FIG. 12, components identical to those of the implementation illustrated in FIG. 11 may be referred to by identical drawing reference numerals. The implementation shown in FIG. 12 may have a positional relationship between the first buffer layer 721 and the second buffer layer 722 that is partially different from the implementation shown in FIG. 11. Hereinafter, differences will be mainly described, and redundant explanations will be omitted or briefly stated.

As shown in FIG. 12, the buffer layer 720 may be positioned between the second electrode 375 and the first semiconductor layer 331. The buffer layer 720 may include a first surface 720a and a second surface 720b opposite to the first surface 720a. The first semiconductor layer 331, the second semiconductor layer 333, the third semiconductor layer 335, and the fourth semiconductor layer 337 are positioned on the first surface 720a of the buffer layer 720, and the second electrode 375 may be positioned on the second surface 720b of the buffer layer 720.

The buffer layer 720 may include the first buffer layer 721 and the second buffer layer 722. The first buffer layer 721 may be positioned on the second buffer layer 722. The first buffer layer 721 may be positioned between the second buffer layer 722 and the first semiconductor layer 331. The second buffer layer 722 may be positioned between the second electrode 375 and the first buffer layer 721.

With respect to the material of the first buffer layer 721 and the thickness in the third direction Z, the explanation regarding the material of the first buffer layer 711 of FIG. 11 and the thickness in the third direction Z may be equally applied. As for the material of the second buffer layer 722, the description of the material of the second buffer layer 712 of FIG. 11 may be equally applied.

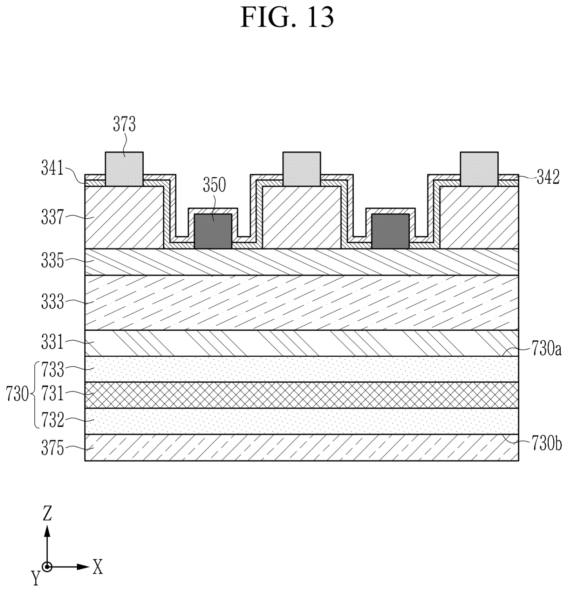

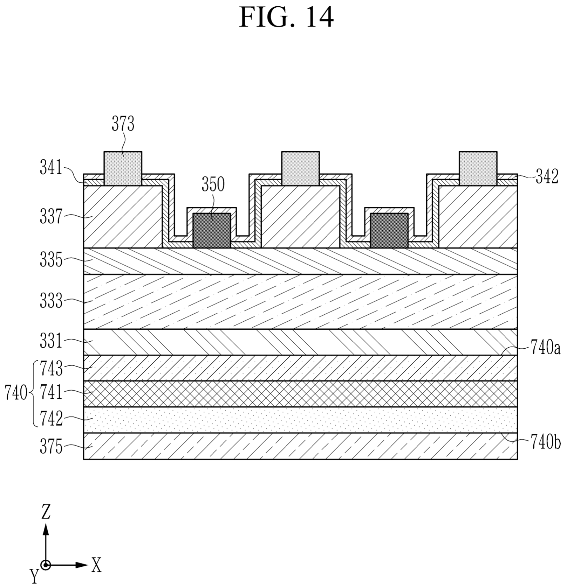

Hereinafter, with reference to FIG. 13 and FIG. 14, variations of the semiconductor device according to the implementation illustrated in FIG. 11 will be described.

FIG. 13 is a cross-sectional view of an example of a semiconductor device. FIG. 14 is a cross-sectional view of an example of a semiconductor device. In the implementation shown in FIG. 13, a buffer layer 730, a first buffer layer 731, and a second buffer layer 732 may correspond to the buffer layer 710, the first buffer layer 711, and the second buffer layer 712 of the implementation shown in FIG. 11. In the implementation shown in FIG. 14, a buffer layer 740, a first buffer layer 741, and a second buffer layer 742 may correspond to the buffer layer 710, the first buffer layer 711, and the second buffer layer 712 of the implementation shown in FIG. 11. In each implementation shown in FIG. 13 and FIG. 14, components identical to those of the implementation shown in FIG. 11 may be referred to by identical drawing reference numerals. In the implementation shown in FIG. 13, the buffer layer 730 may further include a third buffer layer 733, and in the implementation shown in FIG. 14, the buffer layer 740 may further include a third buffer layer 743, such that these aspects may be partially different from the implementation shown in FIG. 11. Hereinafter, differences will be mainly described, and overlapping descriptions may be omitted or briefly stated.

As illustrated in FIG. 13, the buffer layer 730 may be positioned between the second electrode 375 and the first semiconductor layer 331. The buffer layer 730 may include a first surface 730a and a second surface 730b opposite to the first surface 730a. The first semiconductor layer 331, second semiconductor layer 333, third semiconductor layer 335, and fourth semiconductor layer 337 are positioned on the first surface 730a of the buffer layer 730, and the second electrode 375 may be positioned on the second surface 730b of the buffer layer 730.

The buffer layer 730 may include the first buffer layer 731, the second buffer layer 732, and the third buffer layer 733. The first buffer layer 731 may be positioned on the second buffer layer 732. The third buffer layer 733 may be positioned on the first buffer layer 731. The first buffer layer 731 may be positioned between the second buffer layer 732 and the third buffer layer 733. The second buffer layer 732 may be positioned between the second electrode 375 and the first buffer layer 731. The third buffer layer 733 may be positioned between the first buffer layer 731 and the first semiconductor layer 331.

With respect to the material and thickness in the third direction Z of the first buffer layer 731, the explanation concerning the material and thickness in the third direction Z of the first buffer layer 711 of FIG. 11 may be equally applied. With respect to the material of the second buffer layer 732, the description of the material of the second buffer layer 712 of FIG. 1 may be equally applied.

The content of the first element (X) in the third buffer layer 733 may be different from the content of the first element (X) in the first buffer layer 731. The content of the first element (X) in the third buffer layer 733 may be lower than the content of the first element (X) in the first buffer layer 731. For example, the content of the first element (X) in the third buffer layer 733 may be about 0 at% to about 1 at%. For example, the third buffer layer 733 may not include the first element (X). In another example, the third buffer layer 733 may include the first element (X), but the content of the first element (X) may be about 1 at% or less.

In some implementations, the content (at%) of the first element (X) in the third buffer layer 733 may be identical to the content (at%) of the first element (X) in the second buffer layer 732. For example, the second buffer layer 732 and the third buffer layer 733 may not include the first element (X). In another example, the second buffer layer 732 and the third buffer layer 733 may include the first element (X), and the content of the first element (X) may be n (0 < n ≤ 1) at%.

As shown in FIG. 14, the buffer layer 740 may be positioned between the second electrode 375 and the first semiconductor layer 331. The buffer layer 740 may include a first surface 740a and a second surface 740b opposite to the first surface 740a. The first semiconductor layer 331, second semiconductor layer 333, third semiconductor layer 335, and fourth semiconductor layer 337 are positioned on the first surface 740a of the buffer layer 740, and the second electrode 375 may be positioned on the second surface 740b of the buffer layer 740.

The buffer layer 740 may include the first buffer layer 741, the second buffer layer 742, and the third buffer layer 743. The first buffer layer 741 may be positioned on the second buffer layer 742. The third buffer layer 743 may be positioned on the first buffer layer 741. The first buffer layer 741 may be positioned between the second buffer layer 742 and the third buffer layer 743. The second buffer layer 742 may be positioned between the second electrode 375 and the first buffer layer 741. The third buffer layer 743 may be positioned between the first buffer layer 741 and the first semiconductor layer 331.

With respect to the material of the first buffer layer 741 and the thickness according to the third direction Z, the description regarding the material of the first buffer layer 711 of FIG. 6 and the thickness according to the third direction Z may be equally applied. With respect to the material of the second buffer layer 742, the explanation regarding the material of the second buffer layer 712 of FIG. 11 may be equally applied.

The content (at%) of the first element (X) in the third buffer layer 743 may be different from the content (at%) of the first element (X) in the first buffer layer 741. The content (at%) of the first element (X) in the third buffer layer 743 may be lower than the content (at%) of the first element (X) in the first buffer layer 741. For example, in the third buffer layer 743, the content of the first element (X) may be about 0 at% to about 1 at%. For example, the third buffer layer 743 may not include the first element (X). In another example, the third buffer layer 743 may include the first element (X), wherein the content of the first element (X) may be about 1 at% or less.

In some implementations, the content of the first element (X) in the third buffer layer 743 may be different from the content of the first element (X) in the second buffer layer 742. For example, in the third buffer layer 743, the content of the first element (X) may be higher than the content of the first element (X) in the second buffer layer 742. For example, the second buffer layer 742 may not include the first element (X), and the third buffer layer 743 may include the first element (X), but the content of the first element (X) in the third buffer layer 743 may be about 1 at% or less. In another example, the second buffer layer 742 and the third buffer layer 743 may each include the first element (X), the content of the first element (X) in the second buffer layer 742 is s (0<s≤1) at%, and the content of the first element (X) in the third buffer layer 743 may be t (s<t≤1) at%. However, the implementations is not limited thereto. For example, the content (at%) of the first element (X) in the second buffer layer 742 may be higher than the content (at%) of the first element (X) in the third buffer layer 743.

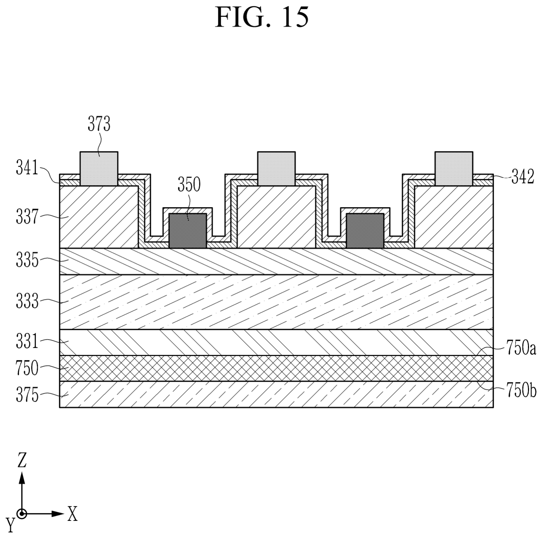

Hereinafter, with reference to FIG. 15, a variation of the semiconductor device according to the implementation illustrated in FIG. 11 will be described.

FIG. 15 is a cross-sectional view of an example of a semiconductor device. In the implementation shown in FIG. 15, a buffer layer 750 may correspond to the buffer layer 710 of the implementation shown in FIG. 11. In the implementation shown in FIG. 15, the components identical to the components of the implementation shown in FIG. 11 may be referenced by identical drawing reference numerals. The implementation shown in FIG. 15 may differ in part from the implementation shown in FIG. 11 in that the entire buffer layer 750 includes a first element (X) homologous to Si, and the content of the first element (X) in the buffer layer 750 is about 10 at% to about 50 at%. Hereinafter, differences will be mainly described, and redundant descriptions will be omitted or briefly stated.

As illustrated in FIG. 15, the buffer layer 750 may be positioned between the second electrode 375 and the first semiconductor layer 331. The buffer layer 750 may include a first surface 750a and a second surface 750b, which is an opposite surface of the first surface 750a. On the first surface 750a of the buffer layer 750, the first semiconductor layer 331, the second semiconductor layer 333, the third semiconductor layer 335, and the fourth semiconductor layer 337 are positioned, and on the second surface 750b of the buffer layer 750, the second electrode 375 may be positioned.

In the implementation shown in FIG. 11, the buffer layer 710 includes the first buffer layer 711 and the second buffer layer 712 having different contents of the first element (X), whereas in the implementation shown in FIG. 15, the buffer layer 750 may be formed as a single layer including the first element (X). The content of the first element (X) in the buffer layer 750 may be identical to the content of the first element (X) in the first buffer layer 711. The content of the first element (X) in the buffer layer 750 may be about 10 at% to about 50 at%. The thickness of the buffer layer 750 in the third direction Z may be the same as the thickness of the first buffer layer 711 in the third direction Z. The thickness of the buffer layer 750 in the third direction Z may be greater than about 0 nm and less than or equal to about 30 nm. The buffer layer 750 of the implementation shown in FIG. 15 may include only the first buffer layer 711 of the implementation shown in FIG. 11.

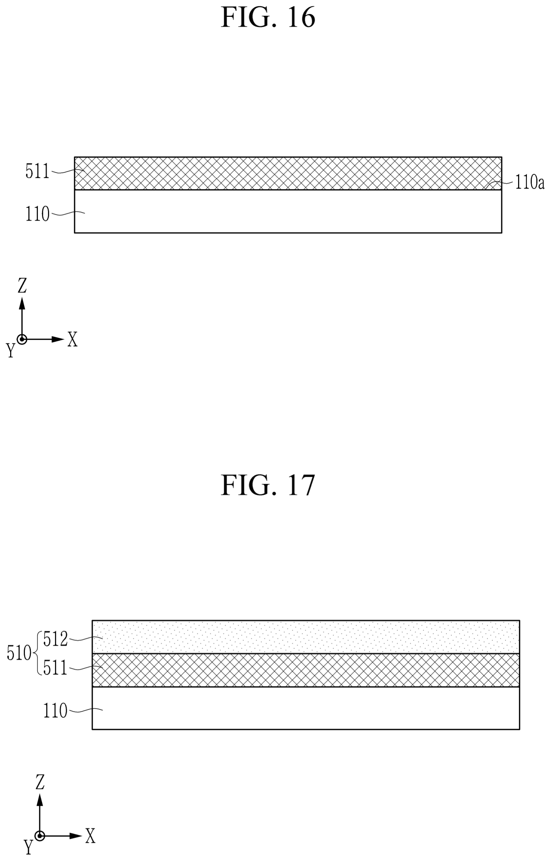

Hereinafter, a method for manufacturing a semiconductor device according to the implementation shown in FIG. 1 will be described with reference to FIGS. 16 to 23.

FIGS. 16, 17, 18, 19, 20, 21, 22, and 23 are cross-sectional views illustrating an example of a method of manufacturing a semiconductor device.

As shown in FIG. 16, a first buffer layer 511 may be formed on a substrate 110.

The substrate 110 may be a semiconductor substrate including SiC. For example, the substrate 110 may be formed of a 4H SiC substrate. In some cases, the substrate 110 may be formed of a 3C SiC substrate, a 6H SiC substrate, and the like. The substrate 110 may have a first conductivity type. The first conductivity type may be n-type; however, it is not limited thereto. The doping concentration of the substrate 110 may be about 1*10¹⁷ cm⁻³ or more and about 5*10²⁰ cm⁻³ or less. The resistivity of the substrate 110 may be about 0.005 Ωcm or more and about 0.035 Ωcm or less. The thickness of the substrate 110 may be about 10 µm or greater and about 700 µm or less. The material, doping type, doping concentration, resistivity, thickness, and the like of the substrate 110 are not limited thereto, and may be variously modified.

The first buffer layer 511 may be formed on the first surface 110a of the substrate 110. A lower surface of the first buffer layer 511 may contact the first surface 110a of the substrate 110. However, the present disclosure is not limited thereto, and a predetermined other layer may be further positioned between the substrate 110 and the first buffer layer 511. The first buffer layer 511 may be an epitaxy layer formed through an epitaxial growth process from the substrate 110.

The first buffer layer 511 may include a first element (X) homologous to Si. The first buffer layer 511 may be formed by injecting the first element (X) during an epitaxial growth process. The first element (X) is an element belonging to the same group as Si, and even when the first element (X) is injected, the carrier concentration or conduction type of the first buffer layer 511 may not be changed. The first buffer layer 511 may include SiₚX_{q}C_{1-p-q}. The content of the first element (X) in the first buffer layer 511 may be about 10 at% to about 50 at%. That is, in the first buffer layer 511, the composition of SiₚX_{q}C_{1-p-q} may be such that p>0 and 0.1≤q≤0.5.

For example, the first element (X) may be Ge. When the first element (X) is Ge, the first buffer layer 511 may include SiₚGe_{q}C_{1-p-q}. The composition of SiₚGe_{q}C_{1-p-q} in the first buffer layer 511 may have p>0 and 0.1≤q≤0.5.

The first buffer layer 511 may have the first conductivity type. The first conductivity type may be n-type. For example, the first buffer layer 511 may be formed by doping a first conductivity type impurity during an epitaxial growth process. The first conductivity type impurity may, for example, be n-type, but is not limited thereto. The doping concentration of the first buffer layer 511 may be lower than the doping concentration of the substrate 110, but is not limited thereto.

The thickness of the first buffer layer 511 in the third direction Z may be greater than about 0 nm and less than or equal to about 30 nm.

As shown in FIG. 17, a second buffer layer 512 may be formed on the first buffer layer 511.

The second buffer layer 512 may be formed on the upper surface of the first buffer layer 511. The second buffer layer 512 may be an epitaxial layer formed through an epitaxial growth process from the first buffer layer 511.

The content of the first element (X) in the second buffer layer 512 may be different from the content of the first element (X) in the first buffer layer 511. The content of the first element (X) in the second buffer layer 512 may be lower than the content of the first element (X) in the first buffer layer 511. The content of the first element (X) in the second buffer layer 512 may be about 0 at% to about 1 at%. For example, the second buffer layer 512 may not include the first element (X). In this case, the second buffer layer 512 may include SiC. In another example, the second buffer layer 512 may include the first element (X), and the content of the first element (X) in the second buffer layer 512 may be about 1 at% or less. In this case, the second buffer layer 512 includes SiₚX_{q}C_{1-p-q}, and in the second buffer layer 512, the composition of SiₚX_{q}C_{1-p-q} may be such that p>0 and 0<q≤1.

The second buffer layer 512 may have the first conductivity type. The first conductivity type may be n-type. The doping concentration of the second buffer layer 512 may be the same (e.g., identical) to the doping concentration of the first buffer layer 511, but is not limited thereto.

The first buffer layer 511 and the second buffer layer 512 may form the buffer layer 510. The buffer layer 510 includes the first buffer layer 511 including a first element homologous to Si, and according to the content of the first element in the first buffer layer 511 being about 10 at% to about 50 at%, crystal defects (e.g., dislocation) present in the substrate 110 may be prevented from being extended to the epitaxial layers formed on the substrate 110 along the crystal growth direction through the epitaxial growth process on the substrate 110. When the thickness of the first buffer layer 511 in the third direction Z is greater than about 0 nm and not more than about 30 nm, the distance over which a defect is propagated through the first buffer layer 511 may be shortened, thereby reducing the defect density reaching the upper layer of the first buffer layer 511.

The buffer layer 510 includes the second buffer layer 512 including a first element homologous to Si, and, in the second buffer layer 512, the content of the first element is about 1 at% or less, such that the film quality of a semiconductor layer (e.g., the second conductivity type semiconductor layer 131 and/or the first conductivity type semiconductor layer 133) to be formed on the buffer layer 510 may be improved.

In another implementation, when the second buffer layer 512 is first formed on the substrate 110, and the first buffer layer 511 is formed on the second buffer layer 512, a semiconductor device according to the implementation shown in FIG. 2 may be manufactured.

In another implementation, the second buffer layer 512 may be first formed on the substrate 110, the first buffer layer 511 may be formed on the second buffer layer 512, and a third buffer layer may be formed on the first buffer layer 511, so that a semiconductor device according to the implementations shown in FIG. 3 and FIG. 4 may be manufactured. At this time, the content of the first element (X) in the third buffer layer may be about 0 at% to about 1 at%. For example, when the content of the first element (X) in the third buffer layer is identical to the content of the first element (X) in the second buffer layer 512, a semiconductor device according to the implementation shown in FIG. 3 may be manufactured. As another example, when the content of the first element (X) in the third buffer layer is different from the content of the first element (X) in the second buffer layer 512, a semiconductor device according to the implementation shown in FIG. 4 may be manufactured.

In another implementation, only the first buffer layer 511 is formed on the substrate 110, and when subsequent processes are performed, a semiconductor device according to the implementation illustrated in FIG. 5 may be manufactured. In this case, the buffer layer 510 of the semiconductor device may include only the first buffer layer 511.

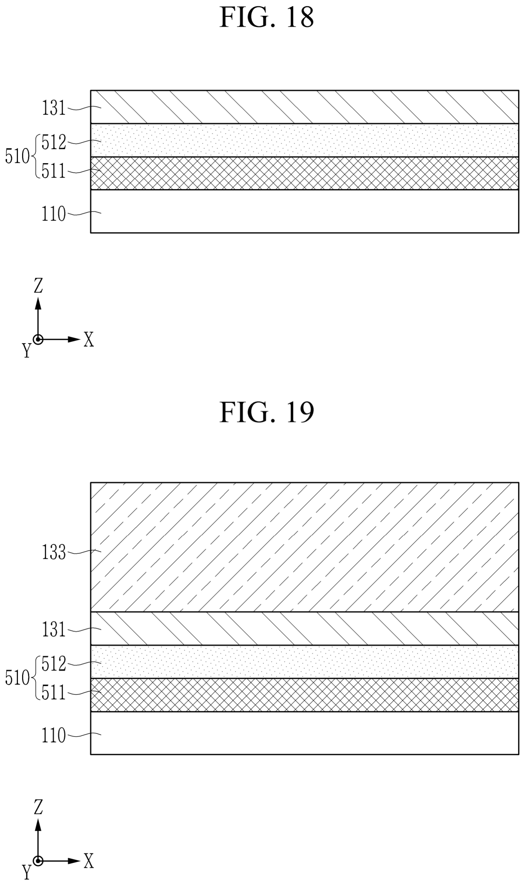

As shown in FIG. 18, a second conductivity type semiconductor layer 131 may be formed on the buffer layer 510.

The second conductivity type semiconductor layer 131 may be formed on the upper surface of the second buffer layer 512. The second conductivity type semiconductor layer 131 may be an epitaxial layer formed by an epitaxial growth process from the second buffer layer 512. The second conductivity type semiconductor layer 131 may include SiC.

The second conductivity type semiconductor layer 131 may include a second conductivity type impurity. For example, the second conductivity type semiconductor layer 131 may be formed by doping the second conductivity type impurity during an epitaxial growth process. The second conductivity type may be p-type. The second conductivity type impurity may, for example, be Al, but is not limited thereto.

As shown in FIG. 19, a first conductivity type semiconductor layer 133 may be formed on the second conductivity type semiconductor layer 131.

The first conductivity type semiconductor layer 133 may be formed on the upper surface of the second conductivity type semiconductor layer 131. The first conductivity type semiconductor layer 133 may be an epitaxial layer formed on the second conductivity type semiconductor layer 131 through an epitaxial growth process. The first conductivity type semiconductor layer 133 may include SiC.

The first conductivity type semiconductor layer 133 may include a first conductivity type impurity. For example, the first conductivity type semiconductor layer 133 may be formed by doping the first conductivity type impurity during an epitaxial growth process. The first conductivity type may be n-type.

The doping concentration of the first conductivity type semiconductor layer 133 may be about 1*10¹⁴cm⁻³ or more and about 1*10¹⁷cm⁻³ or less. The thickness of the first conductivity type semiconductor layer 133 in the third direction Z may be about 1 µm or more and about 13 µm or less. The doping concentration and thickness of the first conductivity type semiconductor layer 133 are not limited thereto and may be variously changed.

In another implementation, without forming the second conductivity type semiconductor layer 131, the first conductivity type semiconductor layer 133 is formed on the buffer layer 510, the first conductivity type semiconductor layer 133 is patterned and spaced apart and arranged in the first direction X, a plurality of pillar trenches each extending in the third direction Z are formed, and a plurality of pillar layers filling the plurality of pillar trenches may be formed through an epitaxial growth process. For example, the plurality of pillar layers filling the inside of the plurality of pillar trenches may be formed by being grown from the side surfaces of the plurality of pillar trenches through a side surface epitaxial growth process. As another example, a pillar material layer filling the inside of the plurality of pillar trenches may be formed by growing from the sidewalls and bottom surfaces of the plurality of pillar trenches through an isotropic epitaxial growth process, and a plurality of pillar layers having an upper surface aligned with (e.g., identical to) the upper surface of the first conductivity type semiconductor layer 133 may be formed by removing a portion of the pillar material layer formed on the upper surface of the first conductivity type semiconductor layer 133. The plurality of pillar layers may be positioned between a plurality of second conductivity type well region 135, which is spaced apart and arranged in a first direction X formed in a subsequent process, and the buffer layer 510. In this case, a semiconductor device according to the implementations shown in FIGS. 6 to 10 may be manufactured.

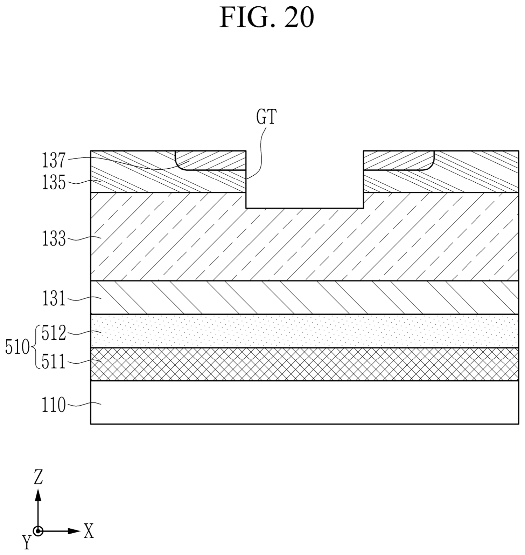

As shown in FIG. 20, the second conductivity type well region 135 and the first conductivity type well region 137 may be formed in the first conductivity type semiconductor layer 133.

The second conductivity type well region 135 and the first conductivity type well region 137 may be formed in the first conductivity type semiconductor layer 133 by an ion implantation process. The second conductivity type well region 135 may be a region doped with an impurity of a second conductivity type, and the first conductivity type well region 137 may be a region doped with an impurity of a first conductivity type. The second conductivity type may be p-type, and the first conductivity type may be n-type.

The doping concentration of the second conductivity type well region 135 may be lower than the doping concentration of the second conductivity type semiconductor layer 131. The doping concentration of the second conductivity type well region 135 may be about 1*10¹⁷ cm⁻³ or more and about 1*10¹⁹ cm⁻³ or less. The thickness of the second conductivity type well region 135 in the third direction Z may be about 0.3 µm or more and about 1.1 µm or less. The doping concentration and thickness of the second conductivity type well region 135 are not limited thereto and may be variously changed.

The doping concentration of the first conductivity type well region 137 may be higher than the doping concentration of the first conductivity type semiconductor layer 133. The doping concentration of the first conductivity type well region 137 may be about 1*10¹⁷ cm⁻¹ or more and about 5*10²⁰ cm⁻³ or less. The thickness of the first conductivity type well region 137 in the third direction Z may be about 0.1 µm or more and about 0.5 µm or less. The doping concentration and thickness of the first conductivity type well region 137 are not limited thereto and may be variously changed.

Subsequently, a gate trench GT may be formed on the first conductivity type semiconductor layer 133, the second conductivity type well region 135, and the first conductivity type well region 137. The gate trench (GT) may be formed by patterning the first conductivity type semiconductor layer 133, the second conductivity type well region 135, and the first conductivity type well region 137 through photolithography and etching processes.

The gate trench GT may extend in the third direction Z from the upper surface of the first conductivity type semiconductor layer 133 toward the lower surface of the first conductivity type semiconductor layer 133. The gate trench GT may have a depth in the third direction Z. The depth of the gate trench GT in the third direction Z may be less than the thickness of the first conductivity type semiconductor layer 133 in the third direction Z. The depth of the gate trench GT in the third direction Z may be greater than the thickness of the second conductivity type well region 135 in the third direction Z and the thickness of the first conductivity type well region 137 in the third direction Z.

The bottom surface of the gate trench GT may be formed by the upper surface of the first conductivity type semiconductor layer 133. A sidewall of the gate trench GT may be formed of a side surface of the first conductivity type semiconductor layer 133, a side surface of the second conductivity type well region 135, and a side surface of the first conductivity type well region 137.

A plurality of second conductivity type well regions 135 spaced apart in the first direction X by the gate trench GT and a plurality of first conductivity type well regions 137 spaced apart in the first direction X by the gate trench GT may be formed. The gate trench GT may be positioned between the plurality of second conductivity type well regions 135 spaced apart in the first direction X and the plurality of first conductivity type well regions 137 spaced apart in the first direction X. The first direction X may be a direction parallel to the upper surface of the first conductivity type semiconductor layer 133.

The gate trench GT may extend in the second direction Y. The second direction Y may be parallel to the upper surface of the first conductivity type semiconductor layer 133, and may be a direction intersecting with the first direction X. For example, the second direction Y may be a direction orthogonal to the first direction X.

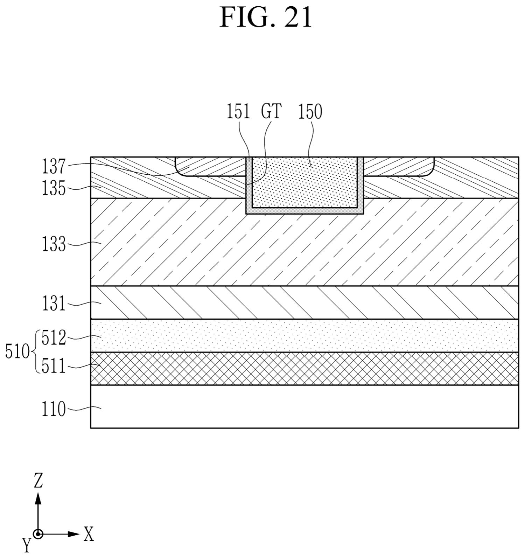

As shown in FIG. 21, a gate insulating layer 151 and a gate electrode 150 may be formed in the gate trench GT. The gate insulating layer 151 may be formed on a bottom surface and sidewalls of the gate trench GT, and the gate electrode 150 may be formed on the gate insulating layer 151.

For example, a gate insulating material layer may be deposited on the bottom surface and sidewalls of the gate trench GT by a deposition process, and a gate electrode material layer may be deposited on the gate insulating material layer. Subsequently, through an etching process, a portion of the gate insulating material layer and the gate electrode material layer covering the upper surfaces of the second conductivity type well region 135 and the first conductivity type well region 137 may be removed, but is not limited thereto.

The gate insulating layer 151 may be formed to have a uniform thickness along the bottom surface and sidewalls of the gate trench GT, and may cover the entire inner surface of the gate trench GT. The gate electrode 150 may fill the remaining space after the gate insulating layer 151 is formed in the gate trench GT. The gate electrode 150 may be surrounded by the gate insulating layer 151. The gate electrode 150 may be spaced apart from the first conductivity type semiconductor layer 133, the second conductivity type well region 135, and the first conductivity type well region 137 by the gate insulating layer 151.

The upper surface of the gate electrode 150 may be positioned at substantially the same level as the upper surface of the second conductivity type well region 135 and the upper surface of the first conductivity type well region 137, but is not limited thereto. For example, the upper surface of the gate electrode 150 may be positioned at a lower level than the upper surface of the second conductivity type well region 135 and the upper surface of the first conductivity type well region 137.

The gate electrode 150 may overlap the second conductivity type well region 135 and the first conductivity type well region 137 in the first direction X. The gate electrode 150 may overlap the first conductivity type semiconductor layer 133 in the first direction X and the third direction Z. The third direction Z may be a direction perpendicular to an upper surface of the first conductivity type semiconductor layer 133.

The gate electrode 150 may be adjacent to the second conductivity type well region 135. When a predetermined voltage is applied to the gate electrode 150, a channel connecting the first conductivity type well region 137 and the first conductivity type semiconductor layer 133 may be formed in the second conductivity type well region 135 with.

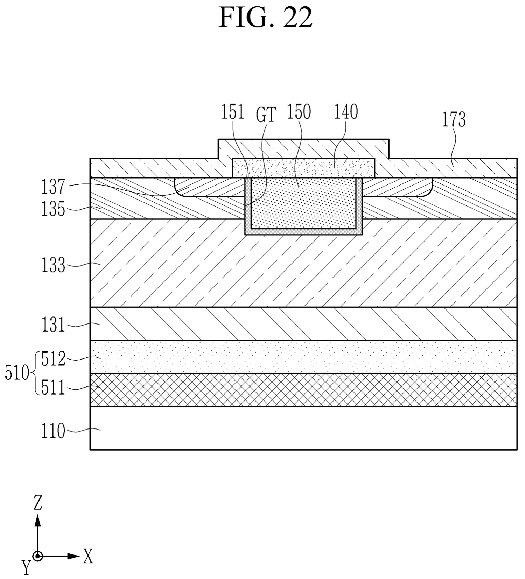

As shown in FIG. 22, a protective layer 140 may be formed on the gate insulating layer 151 and the gate electrode 150, and a first electrode 173 may be formed on the second conductivity type well region 135 and the first conductivity type well region 137.

The protective layer 140 may cover the upper surfaces of the gate insulating layer 151 and the gate electrode 150. The protective layer 140 may further cover a portion of the upper surface of the first conductivity type well region 137 adjacent to the gate electrode 150.

The protective layer 140 may include an insulating material. For example, the protective layer 140 may include silicon oxide, silicon phosphide, silicon nitride, silicon oxynitride, or a combination thereof, but is not limited thereto. The protective layer 140 may be formed as a single layer or a multilayer.

The first electrode 173 may cover upper surfaces of the second conductivity type well region 135 and the first conductivity type well region 137. The first electrode 173 may be electrically connected to the first conductivity type well region 137. For example, the first electrode 173 may contact an upper surface of the first conductivity type well region 137, but is not limited thereto. Another layer may be further positioned between the first electrode 173 and the first conductivity type well region 137. The first electrode 173 may be positioned on both sides of the gate electrode 150 and may be connected to the plurality of first conductivity type well regions 137 spaced apart in the first direction X.

The first electrode 173 may further cover the protective layer 140. The first electrode 173 may cover the side surface and the upper surface of the protective layer 140.

The first electrode 173 may include a conductive material. For example, the first electrode 173 may include a metal, an alloy, a conductive metal nitride, a metal silicide, a doped semiconductor material, a conductive metal oxide, a conductive metal oxynitride, or a combination thereof. The first electrode 173 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAlIN), tungsten nitride (WN), ruthenium (Ru), titanium aluminum (TiAl), titanium aluminum carbonitride (TiAIC-N), titanium aluminum carbide (TiAIC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. The first electrode 173 may be formed as a single layer or a multilayer.

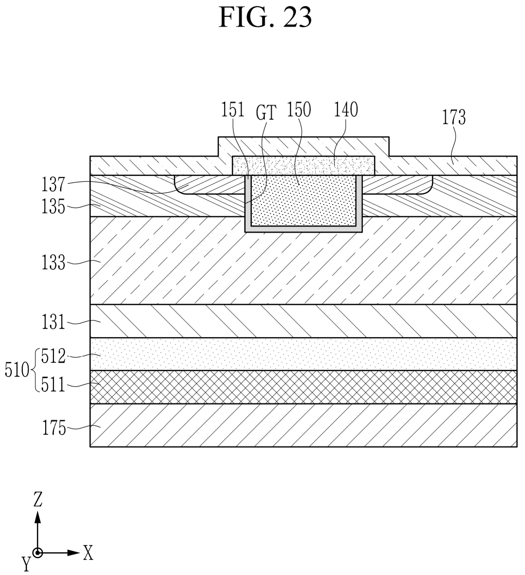

As shown in FIG. 23, the substrate 110 may be removed, and the second electrode 175 may be formed on the opposite surface of the buffer layer 510, which is opposite to surface facing the second conductivity type semiconductor layer 131. However, the implementations are not limited thereto. For example, at least a portion of the substrate 110 may be left without being removed. For instance, the substrate 110 may be left intact, or the thickness of the substrate may be reduced. In this case, the buffer layer 510 is positioned on one surface of the substrate 110, and the second electrode 175 may be positioned on the other surface (opposite surface) of the substrate 110.

The second electrode 175 may include a conductive material. For example, the second electrode 175 may include a metal, an alloy, a conductive metal nitride, a metal silicide, a doped semiconductor material, a conductive metal oxide, a conductive metal oxynitride, or a combination thereof. The second electrode 175 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbonitride (TiAIC-N), titanium aluminum carbide (TiAIC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. The second electrode 175 may be formed as a single layer or a multilayer.

In some implementations, the second electrode 175 may include a material different from the first electrode 173, but is not limited thereto.

In some implementations, a method of manufacturing a semiconductor device includes forming a first buffer layer on a SiC substrate, forming a first conductivity type semiconductor layer on the first buffer layer, forming a second conductivity type well region and a first conductivity type well region in the first conductivity type semiconductor layer, patterning the first conductivity type semiconductor layer, the second conductivity type well region, and the first conductivity type well region to form a gate trench, forming a gate insulating layer and a gate electrode in the gate trench, forming a protective layer on the gate insulating layer and the gate electrode, forming a first electrode on the second conductivity type well region and the first conductivity type well region, and forming a second electrode on a surface of the first buffer layer opposite to the surface facing the first conductivity type semiconductor layer, the first buffer layer including a first element, and the content of the first element in the first buffer layer is 10 at% to 50 at%.

In some implementations, the method may further include a step of forming a second buffer layer between the SiC substrate and the first conductivity type semiconductor layer, and the content of the first element in the second buffer layer may be lower than the content of the first element in the first buffer layer.

In some implementations, the content of the first element in the second buffer layer may be 0 at% to 1 at%.

In some implementations, the second buffer layer may be formed on the first buffer layer.

In some implementations, the second buffer layer is formed on the SiC substrate, and the first buffer layer may be formed on the second buffer layer.

In some implementations, the method may further include a step of forming a third buffer layer between the SiC substrate and the first conductivity type semiconductor layer, and a content of the first element within the third buffer layer may be lower than a content of the first element within the first buffer layer.

In some implementations, the second buffer layer is formed on the SiC substrate, the first buffer layer is formed on the second buffer layer, and the third buffer layer may be formed on the second buffer layer.

In some implementations, the content of the first element in the third buffer layer may be different from the content of the first element in the second buffer layer.

In some implementations, the method may further include a step of forming a second conductivity type semiconductor layer between the first buffer layer and the first conductivity type semiconductor layer.

In some implementations, the method may further include a step of forming a second conductivity type pillar layer between the SiC substrate and the second conductivity type well region.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

Embodiments are set out in the following Clauses:
Clause 1. An SiC semiconductor device comprising:
   a buffer layer,
   a first conductivity type semiconductor layer on a first surface of the buffer layer,
   a second conductivity type well region in the first conductivity type semiconductor layer,
   a first conductivity type well region in the second conductivity type well region,
   a gate electrode adjacent to the second conductivity type well region,
   a gate insulating layer between the gate electrode and the second conductivity type well region,
   a first electrode on the first conductivity type well region, and
   a second electrode on a second surface of the buffer layer, the second surface being opposite to the first surface,
   wherein the buffer layer includes a first buffer layer and a second buffer layer, the first buffer layer and the second buffer layer including SiₚX_{q}C_{1-p-q}, X being an element homologous to Si,
   wherein a composition of SiₚX_{q}C_{1-p-q} in the first buffer layer is p>0, 0.1≤q≤0.5, and
   wherein a composition of SiₚX_{q}C_{1-p-q} in the second buffer layer is p>0, 0≤q≤0.01.
Clause 2. The SiC semiconductor device of Clause 1,
   wherein the second buffer layer is between the first buffer layer and the first conductivity type semiconductor layer.
Clause 3. The SiC semiconductor device of Clause 1 or Clause 2,
   wherein the first buffer layer is between the second buffer layer and the first conductivity type semiconductor layer.
Clause 4. The SiC semiconductor device of Clause 3,
   wherein the buffer layer includes a third buffer layer, the third buffer layer including SiₚX_{q}C_{1-p-q},
   wherein a composition of SiₚX_{q}C_{1-p-q} in the third buffer layer is p>0, 0≤q≤0.01, and
   wherein the third buffer layer is between the first buffer layer and the first conductivity type semiconductor layer.
Clause 5. An SiC semiconductor device comprising:
   a buffer layer,
   a first semiconductor layer of a first conductivity type, a second semiconductor layer of a second conductivity type, a third semiconductor layer of the first conductivity type, and a fourth semiconductor layer of the second conductivity type, the first semiconductor layer, the second semiconductor layer, the third semiconductor layer, and the fourth semiconductor layer being sequentially stacked on a first surface of the buffer layer,
   a gate electrode on an upper surface of the second semiconductor layer or the third semiconductor layer,
   a first electrode on an upper surface of the fourth semiconductor layer, and
   a second electrode on a second surface of the buffer layer, wherein the second surface is an opposite surface to the first surface,
   wherein the buffer layer includes a first buffer layer, the first buffer layer including a first element homologous to Si, and
   wherein a content of the first element in the first buffer layer is 10 at% to 50 at%.

Although implementations of the present disclosure have been described in detail above, the scope of rights of the present disclosure is not limited thereto, and various modifications and improved forms by those skilled in the art using the basic concepts of the present disclosure defined in the following claims are also included within the scope of rights of the present disclosure.

## Claims

1. An SiC semiconductor device comprising:
a buffer layer (510, 520, 530),
a first conductivity type semiconductor layer (133) on a first surface (510a, 520a, 530a) of the buffer layer (510, 520, 530),
a second conductivity type well region (135) in the first conductivity type semiconductor layer (133),
a first conductivity type well region (137) in the second conductivity type well region (135),
a gate electrode (150) adjacent to the second conductivity type well region (135),
a gate insulating layer (151) between the gate electrode (150) and the second conductivity type well region (135),
a first electrode (173) on the first conductivity type well region (137), and
a second electrode (175) on a second surface (510b, 520b, 530b) of the buffer layer (510, 520, 530), the second surface (510b, 520b, 230b) being opposite to the first surface (510b, 520b, 530b),
wherein the buffer layer (510, 520, 530) includes a first buffer layer (511, 521, 531), the first buffer layer (511, 521, 531) including a first element homologous to Si, and
wherein a content of the first element in the first buffer layer (511, 521, 531) is 10 at% to 50 at%.

2. The SiC semiconductor device of claim 1,
wherein the buffer layer (510) includes a second buffer layer (512) between the first buffer layer (511) and the first conductivity type semiconductor layer (133), and
wherein a content of the first element in the second buffer layer (512) is different from the content of the first element in the first buffer layer (511).

3. The SiC semiconductor device of claim 2,
wherein the content of the first element in the second buffer layer (512) is 0 at% to 1 at%.

4. The SiC semiconductor device of claim 1,
wherein the buffer layer (520) includes a second buffer layer (522),
wherein the first buffer layer (521) is between the second buffer layer (522) and the first conductivity type semiconductor layer (133), and
wherein a content of the first element in the second buffer layer (522) is different from the content of the first element in the first buffer layer (521).

5. The SiC semiconductor device of claim 4,
wherein the content of the first element in the second buffer (522) layer is 0 at% to 1 at%.

6. The SiC semiconductor device of claim 1,
wherein the buffer layer (530) includes a second buffer layer (532) and a third buffer layer (533),
wherein the first buffer layer (531) is between the second buffer layer (532) and the third buffer layer (533), and the third buffer layer (533) is between the first buffer layer (533) and the first conductivity type semiconductor layer (133), and
wherein a content of the first element in the second buffer layer (532) and a content of the first element in the third buffer layer (533) are different from the content of the first element in the first buffer layer (531).

7. The SiC semiconductor device of claim 6,
wherein the content of the first element in the second buffer (532) layer is 0 at% to 1 at%, and
wherein the content of the first element in the third buffer layer (533) is 0 at% to 1 at%.

8. The SiC semiconductor device of claim 6 or claim 7,
wherein the content of the first element in the second buffer layer (532) is different from the content of the first element in the third buffer layer (533).

9. The SiC semiconductor device of any preceding claim, comprising a second conductivity type semiconductor layer (131) between the buffer layer (510, 520, 530) and the first conductivity type semiconductor layer (133).

10. The SiC semiconductor device of any preceding claim, comprising a plurality of first conductivity type well regions (237) spaced apart in a first direction and a plurality of second conductivity type well regions (235) spaced apart in the first direction,
wherein a gate trench (GT) is between the plurality of first conductivity type well regions (237), and the gate trench (GT) is between the plurality of second conductivity type well regions (235),
wherein the gate insulating layer (151) and the gate electrode (150) are in the gate trench (GT), and
wherein the gate electrode (150) overlaps the first conductivity type well regions (237) and the second conductivity type well regions (235) in the first direction.

11. The SiC semiconductor device of any of claims 1-9, comprising a second conductivity type pillar layer (233) between the buffer layer (510, 520, 530) and the second conductivity type well region (135).

12. The SiC semiconductor device of claim 11, comprising a plurality of first conductivity type well regions (237) spaced apart in a first direction and a plurality of second conductivity type well regions (235) spaced apart in the first direction,
wherein the first conductivity type semiconductor layer (231) is between the plurality of first conductivity type well regions (237), and the first conductivity type semiconductor layer (231) is between the plurality of second conductivity type well regions (237),
wherein the gate insulating layer (251) and the gate electrode (250) are on an upper surface of the first conductivity type semiconductor layer (231), and
wherein the gate electrode (250) overlaps the plurality of first conductivity type well regions (237) and the plurality of second conductivity type well regions (235) in a direction perpendicular to the upper surface of the first conductivity type semiconductor layer (231).

13. The SiC semiconductor device of any preceding claim,
wherein the first conductivity type is n-type and the second conductivity type is p-type.

14. The SiC semiconductor device of any preceding claim,
wherein the buffer layer (510, 520, 530) has the first conductivity type.

15. The SiC semiconductor device of any preceding claim,
wherein a thickness of the first buffer layer (511, 521, 531) is greater than 0 nm and less than or equal to 30 nm.
